(19) **Europäisches Patentamt / European Patent Office / Office européen des brevets**

(11) **EP 3 504 729 B1**

(12) **FASCICULE DE BREVET EUROPEEN**

(45) Date de publication et mention de la délivrance du brevet:
**08.04.2026 Bulletin 2026/15**

(21) Numéro de dépôt: **17762163.8**

(22) Date de dépôt: **23.08.2017**

(51) Classification Internationale des Brevets (IPC):
**H01L 21/20** *(2006.01)*

(52) Classification Coopérative des Brevets (CPC):
**H10P 14/3411; H10P 14/3412; H10P 14/38**

(86) Numéro de dépôt international:
**PCT/FR2017/052261**

(87) Numéro de publication internationale:
**WO 2018/037189 (01.03.2018 Gazette 2018/09)**

(54) **PROCEDE DE REALISATION D'UNE COUCHE CONTRAINTE EN TENSION A BASE DE GERMANIUM ETAIN**

**VERFAHREN ZUR HERSTELLUNG EINER VERSPANNTEN SCHICHT AUF DER BASIS VON GERMANIUM-ZINN**

**PROCESS FOR PRODUCING A STRAINED LAYER BASED ON GERMANIUM-TIN**

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **26.08.2016 FR 1657987**

(43) Date de publication de la demande:
**03.07.2019 Bulletin 2019/27**

(73) Titulaire: **Commissariat à l'Energie Atomique et aux Energies Alternatives**
**75015 Paris (FR)**

(72) Inventeurs:
• **REBOUD, Vincent**
**75013 Paris (FR)**
• **HARTMANN, Jean-Michel**
**38330 Montbonnot-Saint-Martin (FR)**
• **TCHELNOKOV,Alexei**
**38240 Meylan (FR)**
• **CALVO, Vincent**
**38600 FONTAINE (FR)**

(74) Mandataire: **Santarelli**
**Tour Trinity**
**1 bis Place de la Défense**
**92400 Courbevoie (FR)**

(56) Documents cités:
**EP-A1- 3 151 266      US-A1- 2015 102 465**
**US-A1- 2015 372 454**

**Description**

**DOMAINE TECHNIQUE**

Le domaine de l'invention est celui de la réalisation d'une couche contrainte en tension à base de germanium étain GeSn, dans le but notamment d'obtenir une structure de bandes d'énergie directe. L'invention s'applique en particulier à la réalisation d'un dispositif microélectronique ou optoélectronique comportant une telle couche à base de GeSn en tension.

**ÉTAT DE LA TECHNIQUE ANTÉRIEURE**

Dans diverses applications microélectroniques ou optoélectroniques, il peut être avantageux d'utiliser une couche contrainte en tension réalisée à base de germanium étain. C'est le cas notamment des transistors haute performance où la contrainte subie par le matériau se traduit par une augmentation de la vitesse de déplacement des porteurs de charge, ce qui améliore les performances d'un tel transistor. C'est le cas également des sources de lumière telles que les lasers à pompage électrique, pour lesquelles la couche émissive à base de germanium étain peut présenter une structure de bandes d'énergie directe par l'application d'une contrainte en tension de valeur suffisante.

L'article de Wirths et al intitulé Tensely strained GeSn alloy as optical gain media, Appl. Phys. Lett. 103, 192110 (2013) décrit un exemple de procédé de réalisation d'une couche contrainte en tension à base de germanium étain. Ce procédé comprend la croissance d'une couche épaisse intermédiaire de $Ge_{1-y}Sn_y$, partiellement ou totalement relaxée, sur une couche de nucléation en germanium, puis la croissance sur la couche intermédiaire d'une couche mince de $Ge_{1-x}Sn_x$, dite d'intérêt, dont la proportion atomique d'étain $x_{Sn}$ est inférieure à celle $y_{Sn}$ de la couche intermédiaire. La couche intermédiaire est dite épaisse dans le sens où son épaisseur est supérieure à l'épaisseur critique à partir de laquelle les contraintes mécaniques subies par la couche relaxent plastiquement. La couche épaisse intermédiaire de $Ge_{1-y}Sn_y$ présente, au niveau de sa surface supérieure, un paramètre de maille supérieur à celui de la couche d'intérêt de $Ge_{1-x}Sn_x$, ce qui permet de contraindre en tension la couche d'intérêt. Dans cette configuration, il est attendu qu'une couche mince de $Ge_{1-x}Sn_x$ présente une structure de bandes d'énergie directe lorsque $x_{Sn}$ est inférieure à 10% et lorsque $y_{Sn}$ est supérieure ou égale à 12%. Les auteurs obtiennent effectivement une couche mince à structure de bandes directe pour $x_{Sn}$=8% et $y_{Sn}$=12%.

Cependant, ce procédé de réalisation nécessite la réalisation d'une couche intermédiaire à forte proportion atomique d'étain pour la mise en tension de la couche d'intérêt $Ge_{1-x}Sn_x$. Or, la réalisation d'une telle couche à forte proportion atomique d'étain et de bonne qualité cristalline est particulièrement difficile à obtenir du fait, d'une part, de la différence importante entre le paramètre de maille du germanium ($a_{Ge}$=5,658Å) et celui de l'étain ($a_{Sn}$=6,489Å), et, d'autre part, de la différence entre la température de fusion du germanium (950°C environ) et celle de l'étain (240°C environ) qui peut conduire à une démixtion de l'étain.

**EXPOSÉ DE L'INVENTION**

L'invention a pour objectif de remédier au moins en partie aux inconvénients de l'art antérieur, et plus particulièrement de proposer un procédé de réalisation d'une couche dite d'intérêt, contrainte en tension, à base de germanium étain, ne nécessitant pas de réaliser une couche intermédiaire à base de germanium étain à forte proportion d'étain. Pour cela, l'objet de l'invention est un procédé de réalisation d'une couche contrainte en tension à base de germanium étain, comportant les étapes selon la revendication 1.

Certains aspects préférés mais non limitatifs de ce procédé sont les suivants.

Le procédé peut comporter les étapes suivantes :

- préalablement à l'étape a) de réalisation, estimation d'une valeur de proportion atomique d'étain et d'une première valeur minimale de contrainte en tension pour lesquelles la couche d'intérêt présente une structure de bandes d'énergie directe ; et
- détermination d'un empilement semiconducteur comportant une couche de nucléation et ladite couche d'intérêt estimée, et présentant une deuxième valeur minimale de contrainte en tension ;
- réalisation dudit empilement semiconducteur de sorte qu'il présente ladite valeur initiale non nulle de contrainte en tension et que la couche d'intérêt présente une valeur initiale inférieure à ladite première valeur minimale ;
- détermination de la structuration de sorte que, après l'étape de suspension, la portion centrale de la partie structurée présente une valeur finale de contrainte en tension supérieure ou égale à ladite deuxième valeur minimale, ladite couche d'intérêt ayant alors une valeur finale de contrainte en tension supérieure ou égale à ladite première valeur minimale et présentant alors une structure de bandes d'énergie directe.

L'empilement semiconducteur peut comporter au moins une couche située entre la couche d'intérêt et la couche de nucléation réalisée en un composé semiconducteur présentant un paramètre de maille, dit naturel, inférieur ou égal à celui du matériau à base de germanium étain de la couche d'intérêt.

L'empilement semiconducteur peut présenter une épaisseur inférieure à une épaisseur dite critique.

L'empilement semiconducteur peut comporter des couches supérieure et inférieure à base de germanium étain, dopées selon des types de conductivité différents, situées de part et d'autre de la couche d'intérêt, celle-ci étant non intentionnellement dopée.

Entre les couches dopées supérieure et inférieure d'une part et la couche d'intérêt d'autre part, peut se situer au moins une couche dite barrière à base de germanium, ou à base de germanium étain dont la proportion atomique en étain est inférieure à la valeur de la proportion atomique d'étain de la couche d'intérêt.

Le procédé peut comporter une étape de gravure partielle de la couche de nucléation, cette gravure étant sélective vis-à-vis de la couche d'intérêt, de manière à supprimer la couche de nucléation au niveau de la portion centrale et à en préserver au moins une partie au niveau des portions latérales.

La proportion atomique d'étain de la couche d'intérêt peut être inférieure à 10%.

Le procédé peut comporter en outre une étape de mise en contact de la partie structurée avec une surface rendue libre de la couche support, de manière à rendre solidaire par collage moléculaire la partie structurée de la couche support.

Le procédé peut comporter en outre les étapes suivantes :

- détermination d'une valeur minimale d'énergie de collage moléculaire de la partie structurée sur la couche support, ainsi qu'une valeur minimale de surface collée des portions latérales, ces valeurs minimales étant telles que ladite énergie de collage moléculaire est supérieure à une énergie élastique de la partie structurée ;
- recuit de consolidation à une température de recuit telle que l'énergie de collage moléculaire présente une valeur supérieure ou égale à ladite valeur minimale préalablement déterminée ; puis
- gravure d'une partie dite distale des portions latérales vis-à-vis de la portion centrale, de sorte que la surface collée des portions latérales présente une valeur supérieure ou égale à ladite valeur minimale préalablement déterminée.

L'étape de suspension et l'étape de mise en contact peuvent être effectuées par gravure de la couche sacrificielle par HF en phase vapeur éventuellement suivie par le dépôt puis l'évaporation d'un liquide entre la partie structurée suspendue et la couche support, et dans lequel, lors de l'étape de recuit, la température de recuit est supérieure ou égale à 200°C.

Le procédé peut comporter, lors de l'étape de suspension, une oxydation ou une nitruration d'une surface rendue libre de la couche support ainsi que d'une surface inférieure de la partie structurée orientée vers la surface libre, et dans lequel, lors de l'étape de recuit, la température de recuit est supérieure ou égale à 100°C.

A la suite de l'étape de suspension, des couches diélectriques, issues de l'oxydation ou de la nitruration effectuée, peuvent être formées au niveau de la partie structurée et de la couche support, qui présentent une épaisseur de préférence supérieure ou égale à 10nm.

L'invention porte également sur un procédé de réalisation d'un dispositif microélectronique ou optoélectronique comportant ladite couche d'intérêt à base de germanium étain obtenue par le procédé selon l'une quelconque des caractéristiques précédentes, dans lequel on réalise une jonction PN dans la couche d'intérêt, ou une jonction PIN au niveau de ladite couche d'intérêt, celle-ci étant alors non intentionnellement dopée.

## BRÈVE DESCRIPTION DES DESSINS

D'autres aspects, buts, avantages et caractéristiques de l'invention apparaîtront mieux à la lecture de la description détaillée suivante de formes de réalisation préférées de celle-ci, donnée à titre d'exemple non limitatif, et faite en référence aux dessins annexés sur lesquels :

les figures 1A, 1B et 1C sont des vues schématiques, en coupe (fig.1A et 1C) et de dessus (fig.1B), d'un empilement comportant une couche d'intérêt à base de germanium étain, pour différentes étapes d'un procédé selon un premier mode de réalisation ;

les figures 2A, 2B, 2C sont des vues schématiques, en coupe (fig.2A et 2B) et de dessus (fig.2C), d'un variante de l'empilement illustré sur les figures 1A à 1C ;

la figure 3 illustre un organigramme d'un procédé selon un deuxième mode de réalisation, permettant d'obtenir une couche d'intérêt à structure de bandes directe ;

les figures 4A, 4B et 4C sont des vues schématiques, en coupe, d'une structure semiconductrice pour différentes étapes d'un procédé selon un troisième mode de réalisation ;

les figures 5A et 5B sont des vues schématiques, de dessus, d'une structure semiconductrice, respectivement avec et sans la partie périphérique ; et la figure 5C est un exemple de relation entre l'énergie surfacique de collage en fonction de la température de recuit, pour un collage hydrophile et pour un collage hydrophobe ;

les figures 6A, 6B et 6C sont des vues schématiques, en coupe, d'une structure semiconductrice, pour différentes étapes d'un procédé selon un quatrième mode de réalisation faisant intervenir une étape de collage hydrophile ;

les figures 7A et 7B sont des vues schématiques, en coupe, d'un dispositif optoélectronique à émission de lumière non cohérente comportant une structure semiconductrice obtenue à partir du procédé selon le quatrième mode de réalisation ;

les figures 8A et 8B sont des vues schématiques, en coupe, d'un dispositif optoélectronique à émission de lumière cohérente comportant une structure semiconductrice obtenue à partir du procédé selon le quatrième mode de réalisation ;

les figures 9A à 9F représentent, de manière schématique et en coupe, différentes étapes d'un exemple de procédé de réalisation d'une source laser comportant un empilement semiconducteur obtenu par le procédé selon le premier ou le deuxième mode de réalisation.

## EXPOSÉ DÉTAILLÉ DE MODES DE RÉALISATION PARTICULIERS

Sur les figures et dans la suite de la description, les mêmes références représentent les éléments identiques ou similaires. De plus, les différents éléments ne sont pas représentés à l'échelle de manière à privilégier la clarté des figures. Par ailleurs, les différents modes de réalisation et variantes ne sont pas exclusifs les uns des autres et peuvent être combinés entre eux. Sauf indication contraire, les termes « sensiblement », « environ », « de l'ordre de » signifient à 10% près.

L'invention concerne d'une manière générale un procédé de réalisation d'une couche dite d'intérêt à base de germanium étain contraint en tension, dans le but notamment d'obtenir une structure de bandes d'énergie directe.

Par couche contrainte, on entend une couche réalisée en un matériau semiconducteur monocristallin présentant une contrainte mécanique en tension ou en compression, entraînant une déformation des mailles du réseau cristallin du matériau. La couche est contrainte en tension lorsqu'elle subit une contrainte mécanique qui tend à étirer les mailles du réseau dans un plan. Cela se traduit alors par la présence d'une contrainte en compression orientée suivant un axe sensiblement orthogonal au plan d'étirement. Dans le cadre de l'invention, la couche d'intérêt à base de germanium étain est destinée à être contrainte en tension dans le plan de la couche, ce qui se traduit par le fait que son paramètre de maille présente une valeur dite effective supérieure à sa valeur dite naturelle lorsque le matériau est relaxé, i.e. non contraint. Dans la suite de la description, sauf indication contraire, la contrainte considérée est orientée dans le plan de la couche.

Par couche d'intérêt à base de germanium étain GeSn, on entend que la couche d'intérêt est réalisée en un alliage $Ge_{1-x}Sn_x$ comprenant du germanium et de l'étain. L'alliage de germanium étain peut être un alliage binaire $Ge_{1-x}Sn_x$, ternaire, par exemple $Si_yGe_{1-x-y}Sn_x$, voire quaternaire ou plus. On note $x_{Sn}$ la proportion atomique d'étain dans l'alliage. La couche d'intérêt à base de germanium étain est de préférence formée en un alliage homogène en termes de proportion atomique des éléments formant l'alliage et en termes de valeurs d'un éventuel dopage.

Par structure de bandes directe ou sensiblement directe, on entend que le minimum d'énergie de la vallée L (ou vallée indirecte) est supérieur ou sensiblement égal au minimum d'énergie de la vallée $\Gamma$ (ou vallée directe) de la bande de conduction, autrement dit : $\Delta E = E_{min,L} - E_{min,\Gamma} \geq 0$. Par sensiblement égal, on entend ici que cette différence d'énergie est de l'ordre de grandeur ou inférieure à kT, où k est la constante de Boltzmann et T la température du matériau. Dans le cadre de l'invention, la couche d'intérêt est initialement réalisée à base de germanium étain dont la structure de bandes d'énergie est indirecte lorsque le matériau ne présente pas une contrainte en tension suffisante, autrement dit $\Delta E < 0$, et peut ensuite présenter une déformation en tension suffisante pour rendre directe sa structure de bandes.

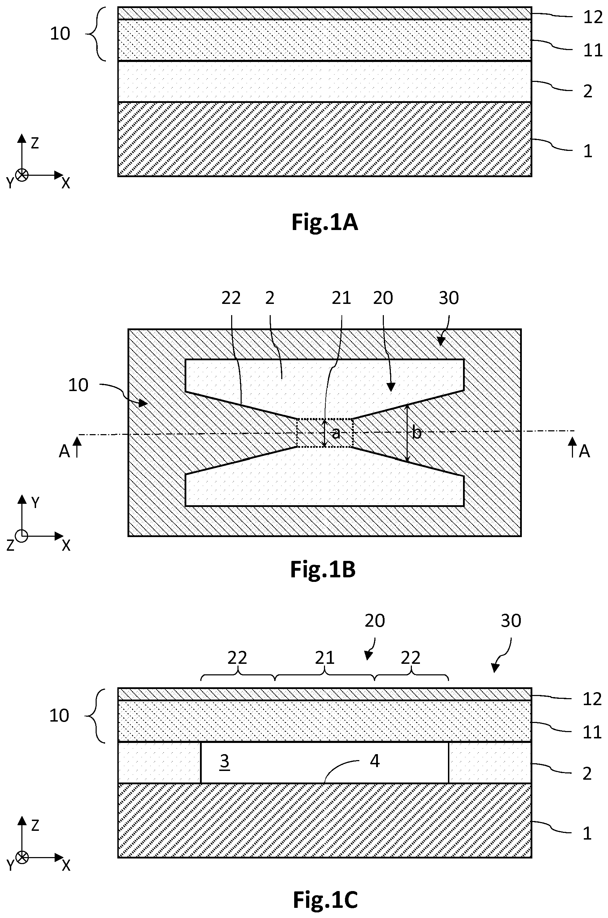

Les figures 1A, 1B et 1C illustrent différentes étapes d'un procédé de réalisation de la couche d'intérêt à base de germanium étain contraint en tension, selon un premier mode de réalisation.

On définit ici et pour la suite de la description un repère direct tridimensionnel (X,Y,Z), où les axes X et Y forment un plan parallèle au plan d'une couche support, et où l'axe Z est orienté suivant l'épaisseur des couches. Dans la suite de la description, les termes « vertical » et « verticalement » s'étendent comme étant relatifs à une orientation sensiblement parallèle à l'axe Z. Par ailleurs, les termes « inférieur » et « supérieur » s'étendent comme étant relatifs à un positionnement croissant lorsqu'on s'éloigne de la couche support suivant la direction +Z.

En référence à la figure 1A, on réalise un empilement semiconducteur 10 comportant des couches semiconductrices, dont au moins une couche de nucléation 11 et la couche d'intérêt 12 à base de germanium étain, ici réalisée en alliage binaire de germanium étain Ge$_{1-x}$Sn$_x$, celle-ci étant épitaxiée à partir de la couche de nucléation 11. L'empilement semiconducteur 10 recouvre une couche sacrificielle 2 reposant sur une couche support 1.

La couche support 1 peut être réalisée en un matériau semiconducteur, électriquement conducteur ou diélectrique. Ce matériau peut présenter une épaisseur de l'ordre de quelques dizaines de nanomètres à quelques centaines de microns, par exemple être comprise entre 10nm et 700$\mu$m, voire comprise entre 500nm et 100$\mu$m. Il est ici réalisé en silicium, mais il peut plus généralement être choisi, entre autres, parmi le silicium, le saphir, le borosilicate, la silice, le verre, le quartz.

La couche sacrificielle 2 peut être réalisée en un matériau apte à être gravé sélectivement par rapport au matériau de la couche support 1 et aux matériaux de l'empilement semiconducteur 10. Il peut être un oxyde de silicium (par exemple SiO$_2$) ou un nitrure de silicium (par exemple Si$_3$N$_4$). La couche sacrificielle 2 peut présenter une épaisseur de l'ordre de quelques dizaines de nanomètres à quelques microns, par exemple être comprise entre 10nm et 10$\mu$m, voire comprise entre 500nm et 5$\mu$m. Elle est ici réalisée en oxyde de silicium SiO$_2$.

La couche de nucléation 11 peut être réalisée en un matériau semiconducteur monocristallin adapté à la nucléation, ou germination, de la couche d'intérêt 12 à base de GeSn. Le matériau de la couche de nucléation 11 peut être choisi parmi les éléments ou composés de la colonne IV de la classification périodique, tel que le germanium, le silicium, l'étain, et les alliages formés de ces éléments tels que GeSn, SiGeSn, SiGe. Il peut également être choisi parmi les composés comportant des éléments des colonnes III et V, tels que GaP, AlP, AlAs, InGaAs, InP, AlGas, voire parmi les composés comportant des éléments des colonnes II et VI, tels que ZnS, ZnSe, CdZnTe, CdTe.

La couche d'intérêt 12 est réalisée en un matériau semiconducteur monocristallin à base de germanium étain et est ici réalisé en un alliage binaire de germanium étain Ge$_{1-x}$Sn$_x$. La proportion atomique d'étain x$_{Sn}$ est non nulle et peut être comprise entre 1% et 14%, de préférence comprise entre 4% et 10%. Elle présente une épaisseur de l'ordre de quelques dizaines de nanomètres à quelques centaines de nanomètres voire à quelques microns, par exemple être comprise entre 10nm et 1$\mu$m.

De manière préférée, chacune des couches formant l'empilement semiconducteur 10 présente une épaisseur inférieure à son épaisseur dite critique à partir de laquelle les contraintes subies par la couche peuvent relaxer et provoquer l'apparition de défauts structuraux, par exemple des dislocations de désaccord de maille, entraînant alors une dégradation potentielle des propriétés électroniques et/ou optiques de la couche. De préférence également, l'épaisseur de l'empilement semiconducteur 10 est inférieure à son épaisseur critique. On minimise ainsi la dégradation de la qualité cristalline de l'empilement semiconducteur 10 et des couches qui le forment.

Selon un mode de réalisation, la couche de nucléation 11 peut être réalisée en un matériau présentant un paramètre de maille inférieur à celui de la couche d'intérêt 12. C'est le cas notamment du germanium Ge, et d'un alliage de germanium étain avec une proportion atomique d'étain inférieure à celle de la couche d'intérêt 12. Ainsi, la couche d'intérêt 12 peut présenter une contrainte en compression vis-à-vis de la couche de nucléation 11, notamment lorsqu'elle est au contact de la couche de nucléation 11 ou lorsqu'une couche intermédiaire de même matériau que la couche d'intérêt 12 est située entre celle-ci et la couche de nucléation 11. La couche de nucléation 11 présente de préférence une épaisseur supérieure à celle de la couche d'intérêt 12.

Selon un autre mode de réalisation, la couche de nucléation 11 peut être réalisée en un matériau présentant un paramètre de maille supérieur à celui de la couche d'intérêt 12. C'est le cas notamment de l'étain et d'un alliage de germanium étain avec une proportion atomique d'étain supérieure à celle de la couche d'intérêt 12. Ainsi, la couche d'intérêt 12 peut présenter une contrainte en tension vis-à-vis de la couche de nucléation 11. La couche de nucléation 11 présente de préférence une épaisseur inférieure à celle de la couche d'intérêt 12.

Dans le cadre de l'invention, l'empilement semiconducteur 10 est réalisé de telle sorte qu'il présente une contrainte en tension non nulle, c'est-à-dire que la contrainte de l'empilement, dans le plan (X,Y), présente une valeur initiale $\sigma_s^i$ non nulle et positive. La contrainte de l'empilement 10 correspond à la moyenne des contraintes de chaque couche de l'empilement, selon la relation :

$$\sigma_s = \sum_{k=1}^{N} E_k\, \varepsilon_k e_k$$

où E$_k$ est le module d'Young de la couche k appartenant à l'empilement, d'épaisseur e$_k$, et $\varepsilon_k$ est la valeur de la déformation subie par la couche k.

Pour cela, on choisit les matériaux des couches et leurs épaisseurs de sorte que la contrainte de l'empilement 10 dans le plan (X,Y) soit strictement positive, autrement dit, de sorte que la contrainte $\sigma_{s,z}^i$ suivant l'axe Z soit en compression, donc négative, selon la relation (1) suivante :

$$\sigma_{s,z}^i = \sum_{k=1}^{N} E_k\, \varepsilon_{k,z}^i e_k < 0 \qquad\qquad (1)$$

où $\varepsilon_{k,z}^i$ est la valeur initiale de la déformation suivant l'axe Z subie par la couche k. Cette valeur initiale $\varepsilon_{k,z}^i$ de la déformation peut être estimée classiquement à partir du paramètre de maille $a_{0,k}$ de la couche k relâchée et du paramètre de maille $a_{z,k}$ de la couche k contrainte à partir de la relation $\varepsilon_{k,z}^i = (a_{z,k} - a_{0,k})/a_{0,k}$. Elle peut également être classiquement estimée à partir des constantes de raideur de la couche k et de la déformation dans le plan (X,Y) subie par la couche k.

A titre d'exemple, la couche de nucléation 11 peut être une couche de germanium déposée ou transférée sur une couche sacrificielle 2 d'oxyde de silicium reposant sur une couche support 1 de silicium. Cet ensemble de couches est de préférence réalisé au moyen du procédé décrit dans la publication de Reboud et al. intitulée Structural and optical properties of 200 mm germanium-on-insulator (GeOI) substrates for silicon photonics applications, Proc. SPIE 9367, Silicon Photonics X, 936714 (February 27, 2015) qui met notamment en œuvre la technologie Smart Cut™.

Pour cela, on effectue tout d'abord la croissance épitaxiale d'une couche de germanium cristallin sur une couche épaisse de silicium. La couche de germanium présente alors, à température ambiante, une déformation résiduelle en tension de l'ordre de 0,2%. On dépose ensuite une couche diélectrique, par exemple un oxyde de silicium, sur la surface libre de la couche de germanium, puis on effectue une implantation d'ions H⁺ dans la couche de germanium. Ensuite, on solidarise la couche diélectrique recouvrant la couche de germanium avec un substrat poignée formée d'une couche diélectrique recouvrant une couche de silicium. On sépare la couche de germanium en deux parties au niveau d'une zone fragilisée par l'implantation d'ions. On obtient ainsi une couche de germanium monocristallin 11 recouvrant une couche sacrificielle 2, ici en oxyde de silicium, qui repose sur une couche support 1, par exemple une couche en silicium d'un substrat SOI. Ce procédé est avantageux dans la mesure où la qualité cristalline de la couche de nucléation 11 est particulièrement élevée et sensiblement homogène suivant l'épaisseur de la couche. A titre d'exemple, la densité de dislocations peut être inférieure à $10^7$ cm⁻² sur toute l'épaisseur de la couche, en particulier à l'interface avec la couche sacrificielle 2.

On obtient ainsi une couche de nucléation 11, contrainte en tension, en germanium. Du fait de la différence de valeurs entre les coefficients de dilatation thermique du germanium et du silicium, après refroidissement à la température ambiante, la couche de nucléation subit une déformation en tension dans le plan (X,Y) de l'ordre de 0,2%, ce qui se traduit par un paramètre de maille effectif de 5,670Å environ alors que le paramètre de maille naturel du germanium relâché est de 5,658Å.

De manière alternative, on peut réaliser la couche de nucléation 11 contrainte en tension par croissance épitaxiale d'une couche de germanium sur un substrat, la couche de germanium étant ensuite recouverte d'une couche d'oxyde de silicium. On solidarise cet empilement par collage moléculaire avec un second empilement formé d'une couche de silicium recouverte d'une couche d'oxyde de silicium, le collage étant réalisé par mise en contact mutuel des couches d'oxydes de silicium. On supprime ensuite totalement le substrat, par exemple par meulage (*grinding,* en anglais), de manière à obtenir ainsi la couche de germanium liée à une couche support 1 de silicium par une couche sacrificielle 2 d'oxyde de silicium. Cette approche est notamment décrite dans la publication de Jan et al. intitulée Tensile-strained germanium-on-insulator substrate for silicon-compatible optoelectronics, Opt. Mater. Express 1, 1121-1126 (2011).

On procède ensuite à la croissance épitaxiale de la couche d'intérêt 12 à base de GeSn à partir de la surface exposée de la couche de nucléation 11, par exemple par une technique de dépôt chimique en phase vapeur (CVD, pour *Chemical Vapor Deposition,* en anglais), éventuellement à basse pression (LPCVD, pour *Low Pressure Chemical Vapor Deposition,* en anglais) ou encore par épitaxie par jets moléculaires (MBE, pour *Molecular Beam Epitaxy,* en anglais).

Les ratios des flux des gaz précurseurs, par exemple $Ge_2H_6$ et $SnCl_4$, sont contrôlés pour obtenir la valeur $x_{Sn}$ de proportion atomique d'étain dans la couche d'intérêt 12. A titre illustratif, la température de croissance peut être comprise entre 300°C et 400°C et la vitesse de croissance peut être de l'ordre de 10 nm/min à 100nm/min. La couche d'intérêt 12 présente alors une contrainte en compression dans le plan (X,Y) dans la mesure où elle présente un paramètre de maille naturel supérieur au paramètre de maille effectif de la couche de nucléation 11.

Les épaisseurs de la couche de nucléation 11 et de la couche d'intérêt 12 sont choisies à l'aide de la relation (1) de sorte que l'empilement semiconducteur 10 présente une contrainte en tension $\sigma_s^i > 0$ dans le plan (X,Y), autrement dit une contrainte en compression $\sigma_{s,z}^i < 0$ suivant l'axe Z.

On peut ainsi obtenir, à titre illustratif, un empilement semiconducteur 10, contraint en tension dans le plan (X,Y), et formé de :

- la couche de nucléation 11 en germanium d'une épaisseur par exemple de 1$\mu$m, présentant une déformation en tension de +0,2% (paramètre de maille effectif de 5,670Å pour un paramètre de maille naturel de 5,658Å), et

- la couche d'intérêt 12 en $Ge_{1-x}Sn_x$ avec une proportion atomique d'étain $x_{Sn}$ de 8%, d'une épaisseur par exemple de 50nm. La couche d'intérêt 12 présente ainsi un paramètre de maille effectif de 5,670Å, égal à celui de la couche de nucléation 11, pour un paramètre de maille naturel de 5,724Å. Elle présente alors une déformation en compression dans le plan (X,Y) de -0,94%.

En référence aux figures 1B, on réalise une structuration de l'empilement semiconducteur 10 de manière à former une partie structurée 20 et une partie périphérique 30, la partie structurée 20 comportant une portion centrale 21 reliée à la partie périphérique 30 par au moins deux portions latérales 22 opposées l'une à l'autre vis-à-vis de la portion centrale 21. La partie structurée 20 comporte ici une unique paire de bras tenseurs 22 destinés à assurer ultérieurement une augmentation de la contrainte en tension uniaxiale de la portion centrale 21, et donc une mise sous tension de la couche d'intérêt 12 située dans la portion centrale 21. La partie structurée 20 est réalisée par des étapes classiques de lithographie optique et/ou électronique puis de gravure de l'empilement, qui ne sont donc pas détaillées ici.

La portion centrale 21 peut présenter une forme, dans le plan (X,Y), sensiblement carrée ou rectangulaire, de quelques centaines de nanomètres à quelques microns de largeur, et de quelques centaines de nanomètres à quelques centaines de microns de longueur. D'autres formes sont possibles, telles que des formes polygonales. Les portions latérales 22, appelées par la suite bras tenseurs 22, relient chacune une bordure de la portion centrale 21 à la partie périphérique 30. Elles sont agencées deux à deux vis-à-vis de la portion centrale 21 de manière à définir au moins un axe de déformation sensiblement rectiligne. Ainsi, une augmentation de la déformation en tension est en mesure d'être générée dans la portion centrale 21 lors de l'étape ultérieure de suspension de la partie structurée 20, et donc une mise sous tension de la couche d'intérêt 12 située dans la portion centrale 21.

Pour cela, on forme les bras tenseurs 22 et la portion centrale 21 pour que la largeur moyenne « b » des bras tenseurs 22 soit supérieure à la largeur moyenne « a » de la portion centrale 21, de préférence dix fois supérieure à cette dernière. Par largeur, on entend la dimension transversale d'une portion ou d'un bras, dans le plan (X,Y), à son axe longitudinal. La portion centrale 21 présente ici une largeur moyenne « a » orientée suivant l'axe Y et sensiblement constante suivant l'axe longitudinal X. Les bras tenseurs 22 présentent une largeur moyenne « b » orientée ici suivant l'axe Y.

En outre, la dimension surfacique dans le plan (X,Y) est choisie de sorte que les bras tenseurs 22 ne présentent sensiblement pas ou peu de déformation à l'issue de l'étape suivante de suspension. Plus précisément, la déformation locale diminue à mesure qu'on s'éloigne de la portion centrale 21 et devient négligeable à une distance supérieure ou égale à une ou deux fois une dimension moyenne de la portion centrale 21. La déformation moyenne des bras tenseurs 22, c'est-à-dire le champ de déformation intégré dans le volume des bras tenseurs 22, présente une valeur inférieure à celle de la portion centrale 21, voire est négligeable vis-à-vis de la déformation moyenne dans la portion centrale 21. Sur l'exemple de la figure 1B, les bras tenseurs 22 présentent une forme de trapèze de sorte que la largeur augmente à mesure que l'on s'éloigne de la portion centrale 21. D'autres formes sont possibles, par exemple une forme où les bras tenseurs 22 présentent une augmentation brusque de largeur vis-à-vis de la portion centrale 21 puis une zone principale à largeur constante.

La structuration peut être réalisée de manière à contrôler la valeur de l'amplification de la contrainte en tension de la portion centrale 21 de l'empilement semiconducteur 10, obtenue ultérieurement lors de la suspension de la partie structurée 20. Pour cela, on prédétermine les paramètres dimensionnels de la partie structurée 20, par exemple les largeurs et longueurs de la portion centrale 21 et des bras tenseurs 22. A titre d'exemple, dans le cas d'une portion centrale 21 rectangulaire, de longueur A et de largeur constante a, et des bras tenseurs 22 rectangulaires de longueur B/2-A/2 et de largeur constante b, un facteur d'amplification f reliant la contrainte finale en tension $\sigma_s^f$ à la contrainte initiale en tension $\sigma_s^i$ peut s'exprimer par la relation (2) formulée dans l'article de Süess et al intitulé Analysis of enhanced light emission from highly strained germanium microbridges, Nature Photon. 7, 466-472 (2013) :

$$f = \frac{2L+B}{B}\left(1 + \frac{A}{B-A}\right)\Big/\left(\frac{a}{b} + \frac{A}{B-A}\right) \qquad (2)$$

où L est la longueur de la couche sacrificielle 2 supprimée sous la partie structurée 20 lors de l'étape de suspension ultérieure. Ainsi, en fonction des paramètres dimensionnels de la partie structurée 20 de l'empilement semiconducteur 10, on est en mesure de contrôler la valeur de l'amplification de la contrainte en tension appliquée à la portion centrale 21 lors de la suspension. Le facteur d'amplification peut également être estimé au moyen d'un logiciel de simulation numérique tel que COMSOL Multiphysics.

En référence à la figure 1C (vue en coupe suivant la ligne AA représentée sur la figure 1B), on réalise la suspension de la partie structurée 20, ce qui va provoquer une amplification de la contrainte en tension subie par la portion centrale 21 de l'empilement semiconducteur 10, et donc une mise sous tension de la couche d'intérêt 12 située dans la portion centrale 21. Pour cela, on réalise une cavité 3 sous la partie structurée 20 de manière à la suspendre au-dessus d'une surface rendue libre 4 de la couche support 1.

La cavité 3 est réalisée par gravure, par exemple par gravure humide, de la couche sacrificielle 2 rendue accessible par des ouvertures obtenues lors de la structuration de l'empilement semiconducteur 10. La gravure humide utilise ici de l'acide fluorhydrique (également appelé HF, pour *Hydrogen Fluoride* en anglais) en phase vapeur. Le flux de vapeur HF peut être faible de manière à graver la couche sacrificielle 2 à une vitesse modérée de l'ordre de 10nm par minute. Plus précisément, le flux de vapeur peut, à titre d'exemple, comporter de l'acide fluorhydrique à 20 hPa (15 torr) de pression partielle, de l'alcool à 1,3 Pa (0,01 torr) et de l'azote à 80 hPa (60 torr). Ainsi, on grave sur toute son épaisseur la partie de la couche sacrificielle 2 située sous la partie structurée 20. La partie structurée 20 est alors suspendue au-dessus de la surface rendue libre de la couche support 1, formant ainsi une cavité 3. La cavité 3 est donc située entre la partie structurée 20 et la surface libre 4 de la couche support 1.

On obtient ainsi une partie structurée 20 suspendue dont les bras tenseurs 22 maintiennent la portion centrale 21 au-dessus de la surface libre 4 de la couche support 1 et génèrent dans la portion centrale 21 une augmentation de la contrainte en tension initiale $\sigma_{S.}^{i}$, suivant le ou les axes de déformation, du fait de la différence de largeur moyenne entre les bras tenseurs 22 et la portion centrale 21. Dans cet exemple, la déformation de la portion centrale 21 peut être suffisante pour obtenir une structure de bandes d'énergie directe de la couche d'intérêt 12 située dans la portion centrale 21.

Le procédé permet ainsi d'obtenir une augmentation de la contrainte en tension de la portion centrale 21 de l'empilement semiconducteur 10, et donc la mise en tension de la couche d'intérêt 12 située dans la portion centrale 21, ceci sans avoir à réaliser une couche intermédiaire à base de germanium étain à forte proportion d'étain, comme le décrit l'article de Wirths et al 2013 mentionné précédemment. La qualité cristalline de l'empilement semiconducteur 10, et en particulier celle de la couche d'intérêt 12 à base de GeSn peut être préservée lorsque l'empilement et ses couches le composant présentent une épaisseur inférieure aux épaisseurs critiques respectives.

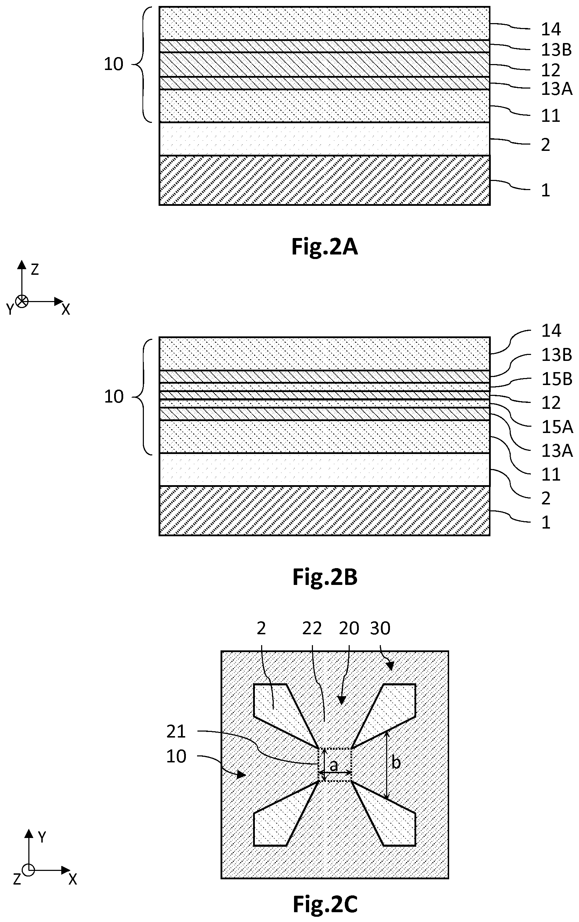

Les figures 2A et 2B sont des vues schématiques, en coupe transversale, de différentes variantes de l'empilement illustré sur la figure 1A, et la figure 2C est une vue schématique, en vue de dessus, d'une variante de la partie structurée 20 illustrée sur la figure 1B.

Sur la figure 2A, l'empilement 10 se distingue de celui illustré sur la figure 1A en ce qu'il comporte en outre deux couches 13A, 13B à base de germanium étain GeSn entre lesquelles est située la couche d'intérêt 12 en contact. Les couches 13A, 13B à base de germanium étain peuvent être réalisées en un alliage binaire de germanium étain, voire ternaire ou quaternaire, et peuvent présenter une proportion atomique d'étain identique ou différente de celle de la couche d'intérêt 12. Dans cet exemple, les couches 13A, 13B sont réalisées dans un matériau identique à celui de la couche d'intérêt 12, à savoir un alliage binaire de germanium étain avec la même proportion atomique d'étain, et en diffèrent par le dopage. En effet, la couche d'intérêt 12 est ici non intentionnellement dopée alors que la couche inférieure 13A présente un dopage selon un premier type de conductivité, par exemple de type N, et la couche supérieure 13B présente un dopage selon un second type de conductivité opposé au premier type, par exemple de type P. Les couches dopées 13A, 13B peuvent présenter des épaisseurs différentes, ici inférieures, de celle de la couche d'intérêt 12. A titre d'exemple, l'épaisseur de la couche d'intérêt 12 peut être de 350nm environ et celles des couches dopées 13A, 13B de 100nm environ. Les couches dopées 13A, 13B peuvent former, avec la couche d'intérêt 12, une diode de type PIN.

L'empilement 10 peut comporter en outre une couche supérieure 14 destinée à assurer un équilibrage des contraintes suivant l'axe Z de l'empilement semiconducteur 10, dans le but de limiter les risques de déformation globale de l'empilement suivant l'axe Z, de type flambement. Cette couche supérieure 14 présente une épaisseur, un module d'Young et une contrainte en tension dans le plan (X,Y) telles que la distribution verticale des contraintes suivant l'axe Z est sensiblement symétrique. Plus précisément, une distribution verticale des contraintes est dite sensiblement symétrique lorsque l'empilement semiconducteur 10 est tel que les sommes $\Sigma_k\ E_k \varepsilon_{k,z} e_k$ relatives aux couches situées de part et d'autre d'un plan médian (parallèle au plan XY) de l'empilement 10 sont égales l'une à l'autre à 10% près. De préférence, la couche supérieure d'équilibrage 14 est réalisée dans le même matériau que celui de la couche de nucléation 11 et présente un produit, épaisseur par contrainte en tension, sensiblement égal à celui de la couche de nucléation 11. Dans cet exemple, la couche de nucléation 11 est réalisée en germanium d'une épaisseur de 1μm environ et présente une déformation en tension dans le plan (X,Y) de 0,2% environ. La couche supérieure d'équilibrage 14 est réalisée en germanium d'une épaisseur de 800nm et présente une déformation en tension de 0,25% environ.

Sur la figure 2B, l'empilement 10 se distingue de celui illustré sur la figure 2A en ce que la couche d'intérêt 12 est séparée des couches dopées 13A, 13B par deux couches intermédiaires dites barrières 15A, 15B qui présentent une énergie de bande interdite supérieure à celle de la couche d'intérêt 12, de manière à améliorer le confinement quantique des porteurs de charge dans la couche d'intérêt 12. Les couches barrières 15A, 15B peuvent être réalisées en un matériau non intentionnellement dopé, de préférence en germanium ou en un alliage de germanium étain, avec une proportion atomique d'étain inférieure à celle de la couche d'intérêt 12. Bien entendu, d'une manière générale, l'empilement semiconducteur 10 peut présenter davantage de couches semiconductrices, à base de germanium étain ou non, dopées ou non, et donc peut comporter plusieurs couches d'intérêt 12.

Sur la figure 2C, la partie structurée 20 se distingue de celle illustrée sur la figure 1B en ce que deux paires de bras tenseurs 22 de dimensions identiques sont représentées, ce qui permet de générer une augmentation biaxiale de la déformation en tension de la portion centrale 21, d'intensité ici sensiblement égale selon les deux axes de déformation ici respectivement parallèles aux axes X et Y. En variante, chaque paire de bras tenseurs 22 peut présenter des dimensions différentes, de manière à déformer la portion centrale avec une intensité différente suivant chacun des axes de déformation.

En variante, le procédé peut également comporter une étape de gravure partielle de la couche de nucléation 11, la gravure étant sélective vis-à-vis de la couche d'intérêt 12, pour ainsi obtenir une portion centrale 21 ne comportant plus la couche de nucléation 11. Ainsi, la portion centrale 21 peut être formée essentiellement de la couche d'intérêt 12, et, le cas échéant, des couches dopées 13A, 13B et éventuellement des couches barrières 15A, 15B. Cette étape de gravure sélective peut être une gravure humide isotrope de la couche de nucléation 11, par exemple au tétrafluorure de carbone (CF4). Le temps de gravure est adapté pour graver l'épaisseur de la couche de nucléation 11, qui peut être de l'ordre de la moitié de la largeur a de la portion centrale 21. Ainsi, à la suite de cette étape de gravure sélective, la couche de nucléation 11 n'est plus présente dans la portion centrale 21 alors qu'elle reste présente au niveau des bras tenseurs 22. La couche supérieure d'équilibrage 14 mentionnée précédemment peut alors être omise dans la mesure où la portion centrale 21 ne comporte pas la couche de nucléation 11 : la distribution verticale des contraintes suivant l'axe Z est sensiblement symétrique.

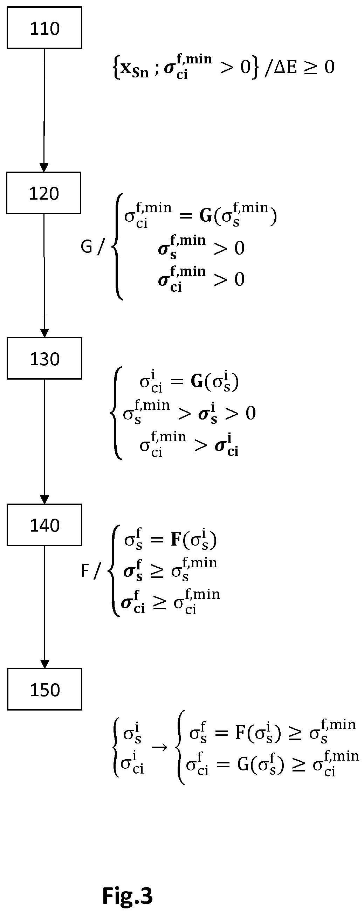

La figure 3 illustre un organigramme d'un procédé selon un deuxième mode de réalisation, permettant d'obtenir une couche d'intérêt 12 à base de germanium étain à structure de bandes directe.

Lors d'une première étape 110, on estime, pour une couche d'intérêt 12 à base de germanium étain $Ge_{1-x}Sn_x$ de proportion atomique en étain $x_{Sn}$, la valeur minimale $\sigma_{ci}^{f,min}$ de contrainte en tension permettant d'obtenir une structure de bandes directe, autrement dit $\Delta E = E_{min,L} - E_{min,\Gamma} \geq 0$. La valeur minimale $\sigma_{ci}^{f,min}$ de contrainte en tension peut être estimée à partir de l'article de Gupta et al. intitulé *Achieving direct band gap in germanium through integration of Sn alloying and external strain,* J. Appl. Phy., 113, 073707 (2013) qui illustre un exemple d'évolution de $\Delta E$ en fonction de la valeur de la contrainte en tension subie par la couche d'intérêt 12 en $Ge_{1-x}Sn_x$ et de la proportion atomique d'étain. Cette évolution est estimée à partir d'une méthode empirique du pseudo-potentiel non local (NL-EPM pour *Non Local Empirical Pseudopotential Method,* en anglais).

Lors d'une deuxième étape 120, on détermine l'empilement semiconducteur 10 comportant une telle couche d'intérêt 12 préalablement déterminée, de propriétés $\{x_{Sn} ; \sigma_{ci}^{f,min}\}$, et présentant alors une contrainte en tension de valeur $\sigma_s^{f,min}$. Les valeurs $\sigma_s^{f,min}$ et $\sigma_{ci}^{f,min}$ sont positives dans la mesure où la contrainte dans le plan (X,Y) est en tension.

Pour cela, on note G la fonction de transfert permettant de déterminer la valeur $\sigma_{ci}^{f,min}$ de la couche d'intérêt 12 à partir de la valeur $\sigma_s^{f,min}$ de l'empilement semiconducteur 10, autrement dit : $\sigma_{ci}^{f,min} = G(\sigma_s^{f,min})$. La fonction de transfert G est paramétrée par les caractéristiques de différentes couches composant l'empilement semiconducteur 10, à savoir les paramètres de maille, les épaisseurs des couches et les modules d'Young et de Poisson respectifs. On détermine donc les paramètres de la fonction de transfert G, par exemple par simulation numérique à l'aide du logiciel COMSOL Multiphysics, ou en vérifiant la relation suivante :

$$\sigma_{s,z}^{f,min} = \sum_{k=1}^{N} E_k \, \varepsilon_{k,z}^{f,min} e_k$$

Lors d'une troisième étape 130, on réalise ledit empilement semiconducteur 10 préalablement déterminé de telle sorte que :

- l'empilement semiconducteur 10 présente une contrainte initiale en tension $\sigma_s^i > 0$ inférieure à la valeur $\sigma_s^{f,min}$, et que

- il comporte la couche d'intérêt 12 de proportion atomique d'étain $x_{Sn}$ et d'une valeur de contrainte initiale $\sigma_{ci}^{i}$ inférieure à $\sigma_{ci}^{min}$ de telle sorte que la structure de bandes est indirecte, la valeur initiale $\sigma_{ci}^{i}$ pouvant être positive (en tension), nulle ou négative (en compression).

Lors d'une quatrième étape 140, on détermine une structuration de l'empilement semiconducteur 10 de manière à former la partie structurée 20 décrite précédemment. La structuration est déterminée de sorte que la suspension de la partie structurée 20 provoque l'augmentation de la contrainte de la portion centrale 21, de la valeur initiale $\sigma_{s}^{i}$ à la valeur finale $\sigma_{s}^{f}$, celle-ci étant alors supérieure ou égale à $\sigma_{s}^{f,min}$.

Pour cela, on note F la fonction de transfert permettant de passer de $\sigma_{s}^{i}$ à $\sigma_{s,}^{f}$, autrement dit : $\sigma_{s}^{f} = F(\sigma_{s}^{i})$. La fonction de transfert F est paramétrée essentiellement par les dimensions de la partie structurée 20, et notamment par la largeur moyenne des bras tenseurs 22 et celle de la portion centrale 21. La fonction de transfert peut être identique ou similaire au facteur d'amplification f mentionné précédemment en référence à la relation (2). On détermine donc les paramètres de la fonction de transfert F, par exemple par simulation numérique à l'aide du logiciel COMSOL Multiphysics ou en vérifiant la relation (2) mentionnée précédemment.

Lors d'une cinquième étape 150, on réalise la mise en suspension de la partie structurée 20 par gravure de la couche sacrificielle 2 située sous la partie structurée 20. Ainsi, dans le même temps :

- la portion centrale 21 de l'empilement passe de la valeur initiale $\sigma_{s}^{i}$ à la valeur finale $\sigma_{s}^{f} = F(\sigma_{s}^{i})$ de contrainte dans le plan (X,Y), la valeur finale $\sigma_{s}^{f}$ étant alors supérieure ou égale à $\sigma_{s}^{f,min}$ ;

- la couche d'intérêt 12 passe de la valeur initiale $\sigma_{ci}^{i}$ à une valeur finale $\sigma_{ci}^{f} = G(\sigma_{s}^{f})$ de contrainte dans le plan (X,Y), cette valeur finale étant alors supérieure ou égale à $\sigma_{ci}^{f,min}$.

On obtient ainsi une couche d'intérêt 12 à base de germanium étain, située au niveau de la portion centrale 21, qui présente une structure de bandes directe, cela sans avoir eu à réaliser une couche de mise en tension à forte proportion atomique d'étain comme le décrit l'article Wirths 2013 cité précédemment. Il est alors possible d'obtenir une structure de bandes directe pour une couche d'intérêt 12 à base de GeSn présentant une proportion atomique d'étain inférieure à 14%, voire inférieure à 10%, voire inférieure 8%, ou moins encore. Comme précédemment, l'empilement et les couches qui le forment peuvent présenter une qualité cristalline préservée lorsque les épaisseurs respectives sont inférieures aux épaisseurs critiques.

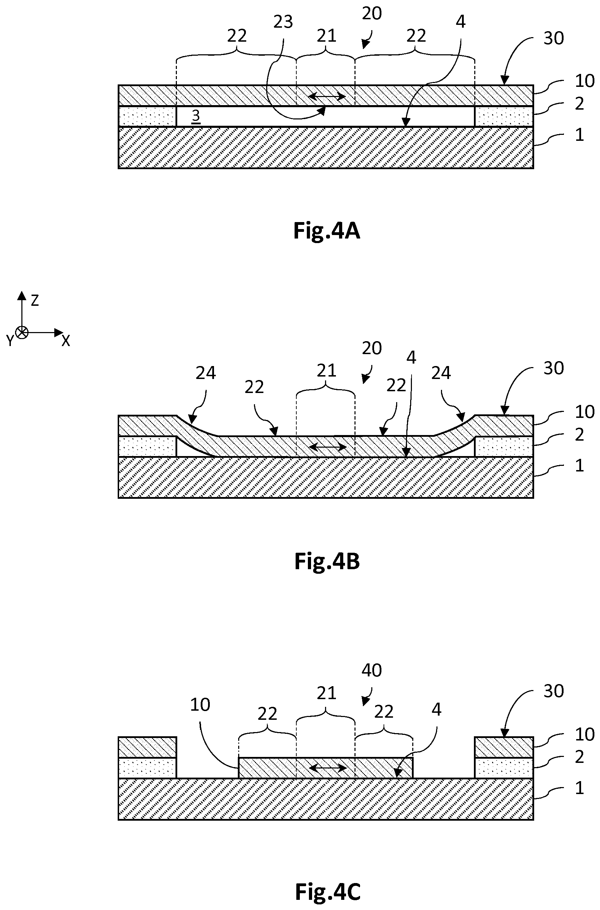

Les figures 4A à 4C illustrent différentes étapes d'un procédé de réalisation d'une structure semiconductrice 40 selon un troisième mode de réalisation, la structure semiconductrice 40 comportant l'empilement 10 à couche d'intérêt 12 à base de germanium étain décrit précédemment, et étant solidarisée par collage direct sur la couche support 1. Ce procédé est similaire à celui décrit dans la demande FR1559283 déposée le 30 septembre 2015. Par ailleurs, par souci de clarté, seul l'empilement semiconducteur 10 est illustré, et non pas la couche de nucléation 11 et la couche d'intérêt 12.

Après l'étape de suspension décrite précédemment, la portion centrale 21 de l'empilement semiconducteur 10 est contrainte en tension et présente alors une énergie élastique Ee, qui, au premier ordre, peut s'écrire : $Ee \sim \sigma_{s}^{f}.\varepsilon_{s}^{f}.V$, où $\sigma_{s}^{f}$ est la valeur moyenne de la contrainte en tension dans le plan (X,Y), $\varepsilon_{s}^{f}$ la valeur moyenne de la déformation correspondant à la contrainte subie, et V le volume de la portion centrale 21.

Par collage direct, également appelé collage moléculaire ou collage par adhérence moléculaire, on entend la solidarisation de deux surfaces de matériaux identiques ou différents l'une contre l'autre, sans apport de couche collante (de type colle, glue, etc...) mais par le biais des forces attractives d'interaction atomique ou moléculaire entre les surfaces à coller, par exemple des forces de Van der Walls, des liaisons hydrogènes, voire des liaisons covalentes. L'empilement semiconducteur 10, solidarisé par collage directe sur la couche support 1, présente alors une énergie de collage qui, au premier ordre, peut s'écrire : $Ec \sim E_{s}.S$, où $E_{s}$ est l'énergie surfacique de collage (on suppose ici que les surfaces à coller présentent une énergie de surface sensiblement égale) et S l'étendue des surfaces collées.

Comme il est détaillé par la suite, le collage moléculaire mis en œuvre ici peut être de type hydrophile ou hydrophobe. Le collage est de type hydrophile lorsqu'il concerne l'adhérence de surfaces hydrophiles, c'est-à-dire de surfaces ayant la capacité à se lier avec des molécules d'eau par un mécanisme d'adsorption. Le collage met alors en jeu des forces de liaison hydrogène dont l'intensité d'interaction est particulièrement élevée. Pour cela, les surfaces hydrophiles sont terminées par des groupements hydroxyles (-OH). Alternativement, le collage peut être de type hydrophobe et concerner alors des surfaces qui n'ont pas la capacité d'adsorber de l'eau. Pour cela, les surfaces hydrophobes peuvent être saturées d'atomes tels que l'hydrogène ou le fluor.

On décrit par la suite, à titre illustratif, un procédé de réalisation d'une structure semiconducteur, comportant l'empilement à couche d'intérêt 12 à base de germanium étain située dans la partie structurée 20, la structure semiconductrice 40 étant collée par adhérence moléculaire à une couche support 1 de silicium.

Selon une première étape, on réalise un empilement semiconducteur 10 comportant la partie structurée 20 (non représentée), reposant sur la couche support 1 par l'intermédiaire d'une couche sacrificielle 2. L'empilement semiconducteur 10 comporte la couche d'intérêt 12 à base de germanium étain (non représentée), et est identique ou similaire aux empilements semiconducteurs décrits précédemment.

Selon une deuxième étape illustrée sur la figure 4A, on réalise une cavité 3 sous la partie structurée 20 de manière à la suspendre au-dessus d'une surface rendue libre de la couche support 1. L'empilement semiconducteur 10 passe alors de la valeur initiale $\sigma_s^i$ à la valeur finale $\sigma_s^f$ de contrainte dans le plan (X,Y), la valeur finale étant alors supérieure ou égale à $\sigma_s^{f,min}$. La couche d'intérêt 12 passe de la valeur initiale $\sigma_{ci}^i$ à une valeur finale $\sigma_{ci}^f$, de contrainte dans le plan (X,Y), cette valeur finale étant de préférence supérieure ou égale à $\sigma_{ci}^{f,min}$, de sorte que la couche d'intérêt 12 présente une structure de bandes directe.

Selon une troisième étape illustrée sur la figure 4B, on effectue la mise en contact de la partie structurée 20 avec la surface libre 4 de la couche support 1. Pour cela, on peut immerger la partie structurée 20 dans une solution liquide, par exemple d'alcool ou d'eau déionisée acidifiée (pH proche de 2), puis on évapore le liquide. Lors de la phase d'évaporation, la partie structurée 20 vient naturellement au contact de la surface libre 4 de la couche support 1. Ainsi, la partie structurée 20 repose sur la couche support 1, de sorte que la surface inférieure d'au moins une partie des bras tenseurs 22 est au contact avec la surface libre 4 de la couche support 1. La surface inférieure de la portion centrale 21 peut être totalement, partiellement, ou pas au contact de la surface libre 4.

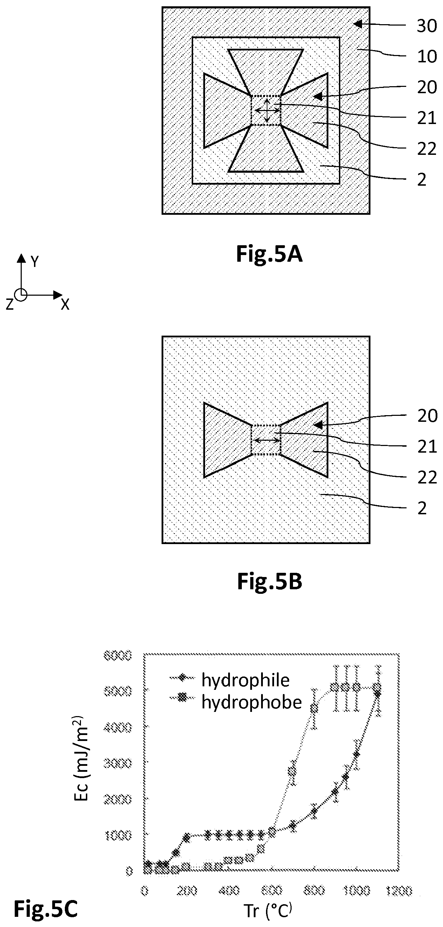

La mise en contact de ces surfaces assure un collage direct de la partie structurée 20 avec la couche support 1, ici de type hydrophobe dans la mesure où les surfaces se solidarisent l'une à l'autre par l'intermédiaire de liaisons hydrogène. A température ambiante, comme l'illustre la figure 5C représentant l'évolution de l'énergie surfacique de collage hydrophobe entre les surfaces collées, l'énergie de collage hydrophobe est ici de l'ordre de 5mJ/m$^2$.

Par mise en contact, on entend le contact de la surface inférieure 23 de la partie structurée 20 avec la surface libre 4 de la couche support 1. Ces surfaces peuvent être formées du matériau composant principalement les couches ou d'un matériau intercalaire différent de ce matériau principal. La partie structurée 20 et la couche support 1 peuvent ainsi comporter une couche mince d'un matériau intercalaire obtenu par exemple par dépôt ou par oxydation, de préférence après formation de la cavité 3. Dans le procédé décrit ici faisant intervenir le collage hydrophobe, la partie structurée 20 et la couche support 1 ne comportent pas de matériau intercalaire.

Ainsi, on obtient une partie structurée 20 de l'empilement semiconducteur 10, collée sur la surface libre 4 de la couche support 1. La partie structurée 20 collée comporte la portion centrale 21 et une partie des bras tenseurs 22. La partie non collée des bras tenseurs 22 est située dans la zone où ceux-ci rejoignent la partie périphérique 30 de l'empilement semiconducteur 10, cette dernière reposant sur la partie non gravée de la couche sacrificielle 2.

En variante, l'étape de suspension et de mise en contact de la partie structurée 20 avec la surface libre 4 de la couche support 1 peut être réalisée dans le même temps. Pour cela, la cavité 3 est par exemple réalisée par gravure humide par HF liquide voire par HF vapeur en haute pression. Dans le cas d'une gravure par HF vapeur, le flux de vapeur peut comporter de l'acide fluorhydrique à 80 hPa (60 torr) de pression partielle, de l'alcool à 13 Pa (0,1 torr) et de l'azote à 100 hPa (75 torr). Le flux de gaz conduit alors à une vitesse de gravure plus importante que celle mentionnée précédemment, par exemple de l'ordre de 100nm/min, lors d'une réaction de gravure hors-équilibre. Aussi, des gouttes d'eau et d'acide fluorhydrique, produits de la réaction chimique, se forment dans la cavité 3 et provoquent, en évaporant, la mise en contact de la partie structurée 20 avec la surface libre 4 de la couche support 1.

A l'issue de cette étape, la partie structurée 20 collée, formée de la portion centrale 21 et des bras tenseurs 22 reposant sur la couche support 1, présente :

  o une énergie de collage Ec, issue du collage moléculaire hydrophobe sur la couche support 1. Elle peut être estimée, au premier ordre, par la relation :

$$E_c \approx E_s\left(S_{bt} + S_{pc}\right)$$

où $E_s$ est l'énergie de surface évaluée à partir de la relation illustrée sur la figure 5C, et $S_{bt}$ et $S_{pc}$ sont les surfaces collées respectives des bras tenseurs 22 et de la portion centrale 21. L'énergie de collage tend à stabiliser la partie structurée 20 collée et à éviter toute relaxation des contraintes susceptibles de modifier sa tenue mécanique ainsi que sa structure cristalline, et donc de dégrader ses propriétés électriques et/ou optiques ;

o une énergie élastique Ee, issue de la contrainte en tension liée à la déformation de la portion centrale 21 par les bras tenseurs 22. Elle peut être estimée, au premier ordre, par la relation :

$$E_e \approx e\left(\sigma_{s,bt}^f . \varepsilon_{s,bt}^f . S_{bt} + \sigma_{s,pc}^f . \varepsilon_{s,pc}^f . S_{pc}\right)$$

où e est l'épaisseur moyenne de l'empilement semiconducteur 10, $\sigma_{s,bt}^f$ et $\sigma_{s,pc}^f$ les valeurs moyennes des contraintes en tension subies, respectivement, par les bras tenseurs 22 et la portion centrale 21, $\varepsilon_{s,bt}^f$ et $\varepsilon_{s,pc}^f$ les valeurs moyennes des déformations correspondantes. L'énergie élastique tend à déstabiliser la partie centrale collée de manière à relaxer naturellement les contraintes.

On peut noter que, au premier ordre, l'énergie de collage comporte un terme prépondérant lié à la surface collée des bras tenseurs 22, celle-ci est généralement supérieure à la surface collée de la portion centrale 21. Par ailleurs, l'énergie élastique comporte un terme prépondérant lié à la déformation de la portion centrale 21, dans la mesure où les bras tenseurs 22 présentent une valeur moyenne de déformation proche de la valeur de déformation résiduelle, celle-ci étant inférieure à la valeur de la déformation subie par la portion centrale 21.

Dans le but de réaliser une structure semiconductrice 40 collée, dont la tenue mécanique et donc les propriétés électriques et/ou optiques sont préservées, qui puisse être séparée de la partie périphérique 30, l'énergie de collage doit être supérieure à l'énergie élastique, ce qui se traduit au premier ordre par l'inégalité suivante :

$$E_s^{min}\left(S_{bt}^{min} + S_{pc}\right) > e\left(\sigma_{s,bt}^f . \varepsilon_{s,bt}^f . S_{bt}^{min} + \sigma_{s,pc}^f . \varepsilon_{s,pc}^f . S_{pc}\right)$$

Pour cela, on détermine à la fois la valeur minimale d'énergie surfacique de collage $E_s^{min}$ et la valeur minimale de surface collée $S_{bt}^{min}$ des bras tenseurs 22, nécessaires pour vérifier cette inégalité. Bien entendu, cette inégalité peut être précisée en utilisant des expressions de l'énergie de collage et de l'énergie élastique plus détaillées, par exemple en intégrant le champ de contrainte dans tout le volume de la partie structurée 20 collée.

Selon une quatrième étape, on effectue un renforcement du collage moléculaire de la partie structurée 20 sur la couche support 1, de manière à obtenir une valeur Es d'énergie surfacique de collage supérieure ou égale à la valeur minimale $E_s^{min}$ déterminée préalablement. Pour cela, on réalise un traitement thermique, sous forme d'un recuit de consolidation, dans lequel on soumet l'empilement à une température de recuit Tr pendant quelques minutes à quelques heures. A titre illustratif, la température de recuit peut être de 200°C appliquée pendant 2h, ce qui augmente ici l'énergie surfacique de collage hydrophobe de 5mJ/m$^2$ à 100mJ/m$^2$. La température de recuit est comprise entre une valeur minimale qui dépend notamment de la surface minimale collée $S_{bt}^{min}$ de bras tenseurs 22 que l'on souhaite conserver et une valeur maximale qui dépend notamment de la qualité cristalline à préserver de l'empilement semiconducteur 10. La valeur maximale de la température de recuit peut ainsi être inférieure à la température de croissance épitaxiale de l'empilement semiconducteur 10. Ainsi, on obtient une partie structurée 20 collée à la couche support 1 avec une énergie de collage Ec dont la valeur est supérieure ou égale à la valeur minimale prédéterminée. On est alors en mesure de supprimer une partie des bras tenseurs 22 pour séparer la partie structurée 20 de la partie périphérique 30.

Dans une cinquième étape illustrée sur les figures 4C, on retire, par gravure, une portion distale 24 des bras tenseurs 22 de manière à séparer, ou individualiser, la partie structurée 20 vis-à-vis de la partie périphérique 30. Par séparer, rendre distincte ou individualiser, on entend ici que la partie structurée 20 n'est plus reliée à la partie périphérique 30 par les bras tenseurs 22. De plus, par portion distale 24 des bras tenseurs 22 vis-à-vis de la portion centrale 21, on entend la zone des bras tenseurs 22 éloignée de la portion centrale 21 et formant le raccord avec la partie périphérique 30. On supprime, par des opérations classiques de lithographie optique et/ou électronique et de gravure, la portion distale des bras tenseurs 22 de manière à ce que la partie structurée 20 collée comporte une valeur de surface collée $S_{bt}$ des bras tenseurs 22 supérieure ou égale à la valeur minimale $S_{bt}^{min}$ déterminée préalablement. Ainsi, la surface collée des bras tenseurs 22 est suffisante pour que la partie structurée 20 collée présente une énergie de collage supérieure à son énergie élastique. Ainsi, on obtient une structure semiconductrice 40 à portion centrale 21 collée sur la couche support 1 dont la tenue mécanique est assurée, préservant ainsi ses propriétés électriques et/ou optiques. La structure semiconductrice 40 présente une qualité cristalline élevée et la portion centrale 21 une déformation moyenne prédéterminée. Elle est solidarisée de la couche support 1 par collage moléculaire dont l'énergie de collage et la surface collée des bras tenseurs 22 permettent de figer le champ des contraintes. Dans la portion centrale 21, la couche d'intérêt 12 à base de GeSn présente une structure de bandes directe.

Sur la figure 5A est illustrée la structure semiconductrice 40 à portion centrale 21, obtenue en séparant la partie structurée 20 de la partie périphérique 30, par gravure de la zone distale des bras tenseurs 22 faisant raccord avec la partie périphérique 30. La figure 5B illustre la structure semiconductrice 40 obtenue à partir de la partie structurée 20 collée en gravant la zone de raccord des bras tenseurs 22 à la partie périphérique 30 (celle-ci étant également supprimée).

La figure 5C illustre un exemple de relation entre l'énergie surfacique de collage entre une surface de germanium de la couche de nucléation 11 et une surface de silicium de la couche support 1, en fonction de la température de recuit, dans le cas d'un collage de type hydrophile et d'un collage de type hydrophobe. Jusqu'à 600°C environ, l'énergie surfacique de collage présente une valeur inférieure dans le cas hydrophobe que dans le cas hydrophile. La tendance s'inverse ensuite à partir de 600°C environ. Par ailleurs, dans le cas hydrophile, l'énergie surfacique augmente dès qu'un recuit à 100°C environ est appliqué, et l'on passe d'une énergie de l'ordre de $100mJ/m^2$ à température ambiante à $1J/m^2$ après un recuit à 200°C environ. Dans le cas hydrophobe, on passe d'une énergie de l'ordre de $5mJ/m^2$ à température ambiante à $100mJ/m^2$ après un recuit à 200°C environ.

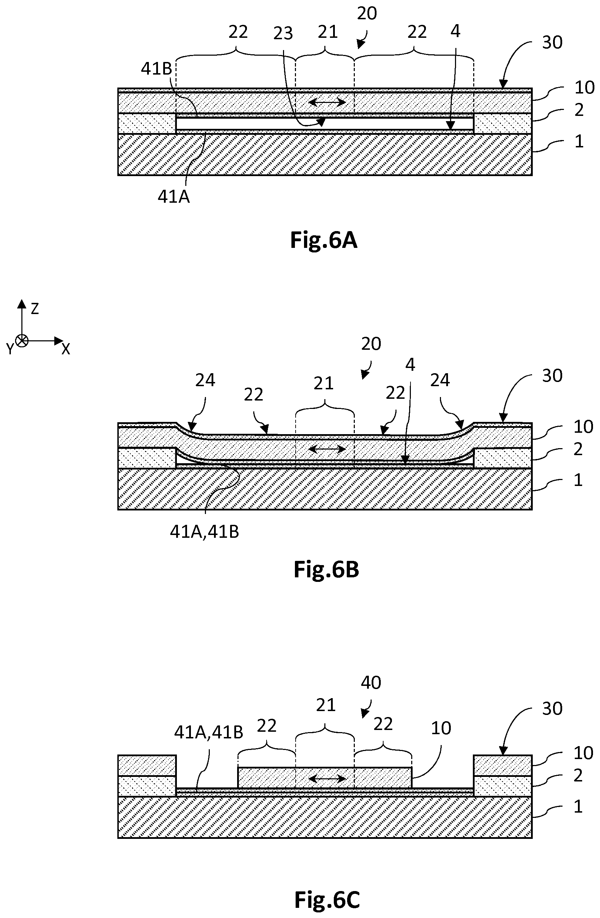

En variante, selon un quatrième mode de réalisation décrit en référence aux figures 6A à 6C, il est possible de réaliser un collage moléculaire de type hydrophile de la partie structurée 20 sur la couche support 1, selon un procédé identique ou similaire à celui décrit dans la demande FR1559283 déposée le 30 septembre 2015 citée précédemment.

En référence à la figure 6A, préalablement à la mise en contact de la partie structurée 20 suspendue sur la couche support 1, on effectue une étape de traitement de surface de la partie structurée 20 et de la surface libre 4 de la couche support 1, dans le but d'assurer ultérieurement le collage moléculaire hydrophile de ces éléments. Lors de cette étape, on traite la surface 23 de la partie structurée 20 en regard de la cavité 3 et la surface libre 4 de la couche support 1 de sorte qu'elles soient formées chacune d'une couche mince 41A, 41B d'oxyde ou de nitrure, d'une épaisseur de quelques nanomètres à quelques dizaines de nanomètres.

Selon une variante, la partie structurée 20 et la couche support 1 sont recouvertes, au niveau de la cavité 3, d'une couche mince 41A, 41B dite intercalaire d'oxyde réalisée par oxydation, par exemple obtenues par mise à l'air libre de cette zone de l'empilement pendant une durée suffisante, par exemple 1h. Elles peuvent également être obtenues par une technique d'oxydation par plasma $O_3$, par exemple à température ambiante, voire par une technique d'oxydation par plasma $0_2$, par exemple à une température de 250°C. Selon une autre variante, les couches minces d'oxyde ou de nitrure sont obtenues par une technique de dépôt de couche mince, par exemple du type ALD (pour *Atomic Layer Deposition,* en anglais) assisté ou non par plasma.

En référence à la figure 6B, on réalise ensuite la mise en contact de la partie structurée 20 avec la surface libre 4 de la couche support 1, par exemple en immergeant la partie structurée 20 suspendue dans une solution liquide, par exemple d'alcool ou d'eau déionisée acidifiée (pH proche de 2), puis en évaporant le liquide. La mise en contact de ces surfaces assure un collage direct de type hydrophile de la partie structurée 20 sur la couche support 1 au niveau des couches intercalaires 41A, 41B respectives. A température ambiante, comme l'illustre la figure 5C, l'énergie de collage hydrophile est ici de l'ordre de $100mJ/m^2$. Ces couches intercalaires 41A, 41B présentent une épaisseur de l'ordre de quelques dizaines de nanomètres à une ou plusieurs centaines de nanomètres, et sont avantageusement diélectriques et peuvent assurer l'isolation électrique de la portion centrale 21 vis-à-vis de la couche support 1.

On effectue ensuite une étape de détermination de la valeur minimale d'énergie surfacique de collage $E_s^{min}$, ici hydrophile, et la valeur minimale de surface collée $S_{bt}^{min}$ des bras tenseurs 22, nécessaires pour que l'énergie de collage hydrophile de la partie structurée 20 soit supérieure à l'énergie élastique de cette même partie structurée 20.

On effectue ensuite une étape de renforcement du collage moléculaire de la partie structurée 20 solidarisée à la couche support 1, de manière à obtenir une valeur Es d'énergie surfacique de collage hydrophile supérieure ou égale à la valeur minimale $E_s^{min}$ déterminée préalablement. Pour cela, on réalise un traitement thermique, sous forme d'un recuit de consolidation, dans lequel on soumet l'empilement à une température de recuit Tr pendant quelques minutes à quelques heures. A titre illustratif, la température de recuit peut être de 200°C appliquée pendant 2h, ce qui augmente ici l'énergie surfacique de collage hydrophile de $100mJ/m^2$ à $1J/m^2$.

En référence à la figure 6C, on retire, par gravure, une partie distale 24 des bras tenseurs 22 de manière à individualiser la partie structurée 20 vis-à-vis de la partie périphérique 30. Cette étape est similaire à l'étape décrite précédemment en référence à la figure 5C et n'est pas détaillée davantage ici. Ainsi, on obtient une structure semiconductrice 40 à portion centrale 21 collée par adhérence moléculaire hydrophile sur la couche support 1, dont la tenue mécanique est assurée et les propriétés électriques et/ou optiques préservées. La couche centrale comporte la couche d'intérêt 12 à base de GeSn dont la structure de bandes est avantageusement directe.

Le procédé selon ce mode de réalisation se distingue donc du procédé décrit précédemment essentiellement par le collage hydrophile, dont l'intensité est supérieure à celle du collage hydrophobe jusqu'à des températures de recuit de l'ordre de 500°C à 600°C, et par la présence d'une couche 41A, 41B d'un oxyde ou nitrure intercalaire à l'interface entre la partie structurée 20 et la couche support 1, dont la propriété diélectrique assure une isolation électrique entre ces éléments. Ce matériau intercalaire, outre une fonction d'isolation électrique, peut également assurer une fonction d'évacuation de la chaleur éventuellement produite au niveau de la portion centrale 21, dans le cas où cette dernière forme une couche émissive d'une source lumineuse.

De manière avantageuse, une pluralité de structures semiconductrices 40 peut être réalisée de manière collective et simultanée, à partir du même empilement semiconducteur 10. Les structures semiconductrices sont alors adjacentes et séparées les unes des autres. Ainsi, chaque structure semiconductrice 40 est distincte de ses voisines, c'est-à-dire non rattachée à la partie périphérique 30 correspondante du même empilement semiconducteur 10.

On décrit maintenant la réalisation de différents dispositifs optoélectroniques comportant la structure semiconductrice 40 à couche d'intérêt 12 à base de germanium étain contraint en tension, obtenue par l'un ou l'autre des procédés décrits précédemment.

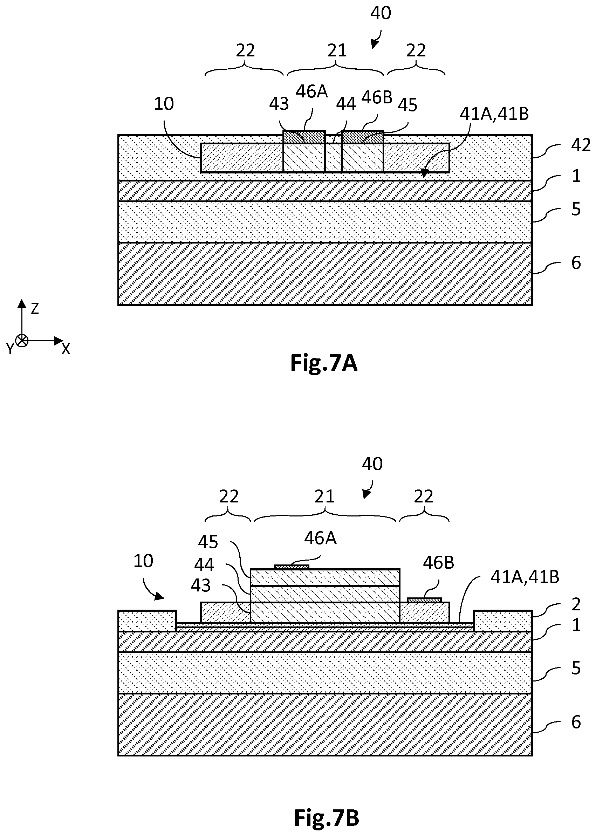

Les figures 7A et 7B représentent, de manière schématique, des vues en coupe de deux exemples d'un dispositif optoélectronique à émission de lumière non cohérente. Le dispositif optoélectronique est ici une diode électroluminescente.

Sur la figure 7A, la diode électroluminescente comporte ici une structure semiconductrice 40 obtenue par le procédé de réalisation selon le quatrième mode de réalisation, c'est-à-dire faisant intervenir un collage moléculaire hydrophile.

La structure semiconductrice 40 comporte une portion centrale 21 en tension dans laquelle la couche d'intérêt 12 à base de GeSn (non représentée) présente de préférence une structure de bandes directe. Elle est solidarisée à la couche support 1 par collage moléculaire hydrophile, ce qui se traduit par la présence d'un matériau intercalaire 41A, 41B, ici un oxyde de silicium, situé à l'interface entre le germanium de la couche de nucléation 11 (non représentée) de l'empilement semiconducteur 10 et le silicium de la couche support 1. La couche support 1 est ici une couche supérieure en silicium d'un substrat, par exemple de type SOI. Elle repose sur une couche d'oxyde 5 située entre la couche support 1 et une couche inférieure épaisse 6 de silicium.

La structure semiconductrice 40 comporte en outre une couche d'encapsulation 42 qui recouvre la portion centrale 21 et les bras tenseurs 22. Cette couche d'encapsulation 42 peut être en un matériau diélectrique présentant une bonne conductivité thermique, tel que l'$Al_2O_3$ ou le $Si_3N_4$. Le $Si_3N_4$ peut en outre contribuer à induire une contrainte en tension dans l'empilement semiconducteur 10. La portion centrale 21 comporte une jonction PIN réalisée par implantation de dopants (phosphore et bore) de manière à former une zone 45 dopée N voisine d'une zone 43 dopée P. Ici, une zone intrinsèque 44 (non intentionnellement dopée) sépare les zones dopées N et P. La jonction PIN s'étend de manière sensiblement verticale au-travers de la portion centrale 21 et donc de la couche d'intérêt 12 à base de GeSn (non représentée), en direction de la couche support 1. Par ailleurs, deux plots 46A, 46B d'un matériau électriquement conducteur sont présents au niveau des zones dopées, formant des contacts électriques.

La diode électroluminescente peut être obtenue de la manière suivante. On réalise tout d'abord l'empilement semiconducteur 10 selon le deuxième mode de réalisation de sorte que la couche d'intérêt 12 à base de GeSn ait une structure de bandes directe, puis on réalise la structure semiconductrice 40 par le procédé selon le quatrième mode de réalisation (collage hydrophile). On réalise ensuite les zones dopées 43, 45 par implantation d'impuretés, par exemple du phosphore et du bore. Les contacts électriques 46A, 46B sont ensuite réalisés. Une couche d'encapsulation 42 est ensuite déposée puis aplanie par une technique de polissage mécano-chimique de type CMP (pour *Chemical Mechanical Polishing,* en anglais) puis localement gravée de manière à rendre accessibles les contacts électriques.

La figure 7B illustre une variante de la diode électroluminescente illustrée sur la figure 7A, qui s'en distingue essentiellement en ce qu'une jonction PIN s'étend de manière sensiblement parallèle au plan de la couche support 1.

La portion centrale 21 est structurée dans son épaisseur, de manière à présenter une partie inférieure 43 à base de GeSn dopé selon un premier type de conductivité, ici de type P, reposant sur la couche de nucléation 11 (non représentée). Cette partie 43 dopée P est reliée aux bras tenseurs 22 et présente une épaisseur moyenne sensiblement identique à celle des bras. Sur la partie inférieure dopée P repose une partie supérieure 45 à base de GeSn dopée selon un second type de conductivité, ici de type N. Une partie intrinsèque 44 à base de GeSn est située entre la partie supérieure 45 dopée N et la partie inférieure 43 dopée P, et présente ici des dimensions dans le plan (X,Y) sensiblement identiques à celles de la partie supérieure. La partie intrinsèque 44 correspond avantageusement à la couche d'intérêt 12 à structure de bandes directes (non représentée). Ainsi, les parties 43, 45 dopées P et N et la partie intrinsèque 44 forment ensemble une jonction PIN qui s'étend suivant un plan sensiblement parallèle au plan (X,Y). Deux plots 46A, 46B d'un matériau électriquement conducteur, formant des contacts électriques, sont disposés sur la partie supérieure dopée N et sur une zone libre de la partie inférieure dopée P.

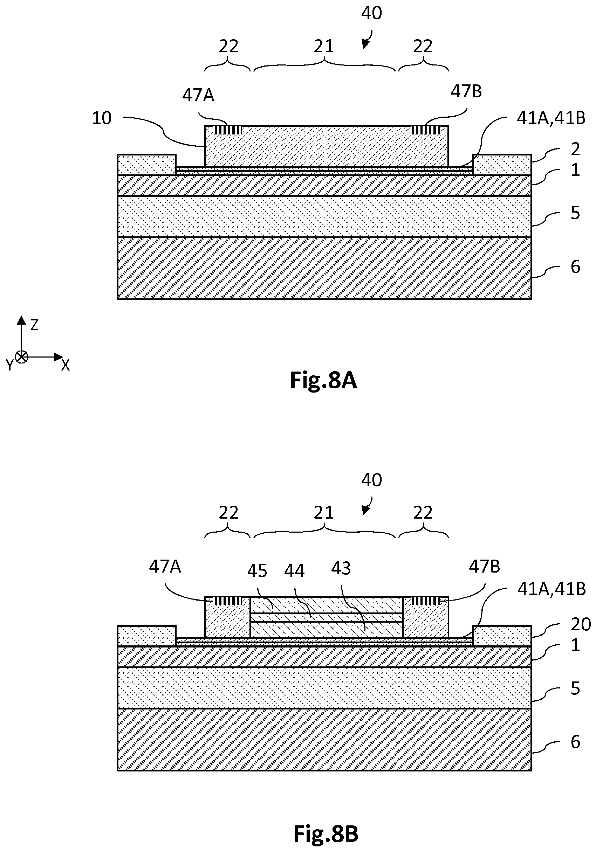

Les figures 8A et 8B représentent de manière schématique une vue en coupe des exemples d'un dispositif optoélectronique à émission de lumière cohérente. Plus précisément, le dispositif optoélectronique est ici une source laser à pompage optique ou électrique.

Sur la figure 8A, la source laser comporte ici une structure semiconductrice 40 obtenue par le procédé de réalisation selon le quatrième mode de réalisation, c'est-à-dire faisant intervenir un collage moléculaire hydrophile. La source laser comporte ici une structure semiconductrice 40 formée d'une portion centrale 21 de l'empilement 10 en tension à couche d'intérêt 12 à base de GeSn (non représentée) à structure de bandes avantageusement directe, et solidarisée à la couche support 1 par collage moléculaire hydrophile.

La couche d'intérêt 12 de la structure semiconductrice 40 est ici intrinsèque voire dopée, par exemple avec du phosphore pour peupler la vallée indirecte de la bande de conduction, et une cavité optique est réalisée à l'intérieur de laquelle se situe la portion centrale 21, qui forme ici un milieu à gain apte à émettre de la lumière. Pour cela, et à titre illustratif, deux miroirs de Bragg 47A, 47B sont disposés sur la face supérieure des bras tenseurs 22, de préférence dans une zone où la déformation des bras tenseurs 22 est sensiblement égale à la valeur résiduelle.

La figure 8B illustre une variante de la diode électroluminescente illustrée sur la figure 8A, qui s'en distingue essentiellement en ce qu'une jonction PIN s'étend de manière sensiblement parallèle au plan de la couche support 1 dans la portion centrale 21. La portion centrale 21 comporte ici un empilement d'une première partie inférieure 43 à base de GeSn, située à proximité de la couche support 1 (et séparée de celle-ci par la couche de nucléation 11), dopée selon un premier type de conductivité, par exemple de type P, recouverte d'une partie intermédiaire intrinsèque 44 correspondant à la couche d'intérêt 12 (non représentée), elle-même recouverte d'une partie supérieure 45 à base de GeSn dopée selon un second type de conductivité opposé au premier type, par exemple de type N. Une cavité optique, similaire à celle décrite en référence à la figure 8A, est réalisée au niveau de la face supérieure des bras tenseurs 22. Par ailleurs, deux contacts électriques (non représentés) sont prévus pour être en contact l'un avec la partie supérieure dopée N et l'autre avec la partie inférieure dopée P.

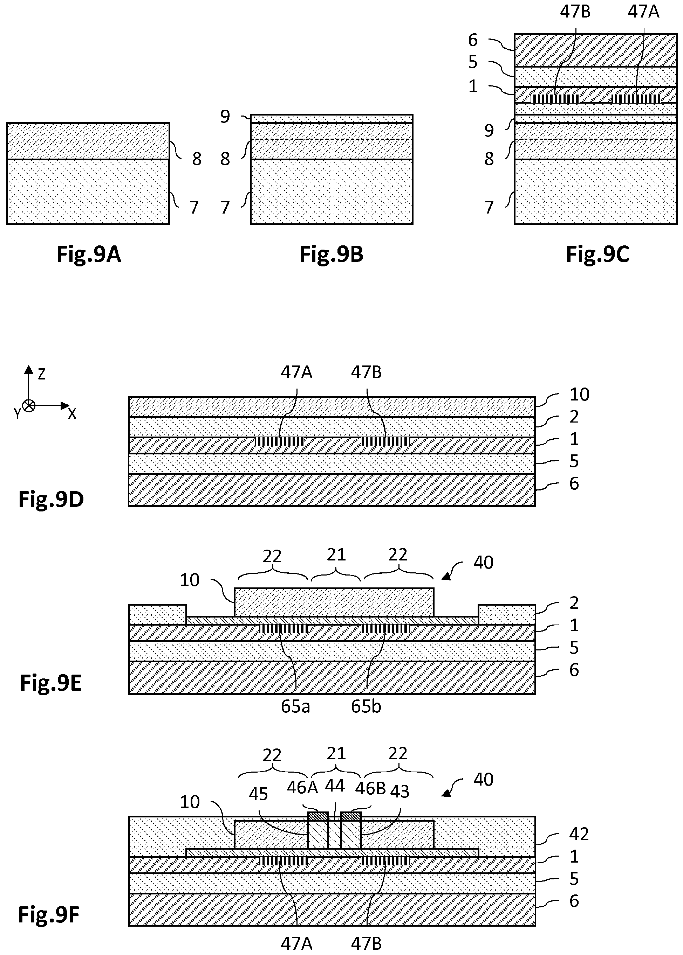

Les figures 9A à 9F représentent de manière schématique en vue en coupe différentes étapes d'un exemple de procédé de réalisation d'une source laser dans laquelle la cavité optique est réalisée au niveau de la couche support 1.

Dans cet exemple, on réalise, par exemple par épitaxie RP-CVD (pour *Reduced Pressure Chemical Vapor Deposition,* en anglais), une couche d'un matériau semiconducteur 8, ici du germanium, sur un substrat 7 de silicium (figure 9A). On recouvre ensuite la couche de germanium 8 d'une couche d'oxyde 9 puis on implante des ions H+ dans la couche de germanium 8 (trait pointillé sur la figure 9B). On réalise ensuite une couche en silicium 1 destinée à former la couche support 1, ici sous forme d'un substrat SOI, dans laquelle on réalise au niveau de sa surface, deux miroirs de Bragg 47A, 47B (ou des éléments optiques équivalents) destinés à former une cavité optique. La surface de la couche support 1 est ensuite recouverte d'une couche d'oxyde. On solidarise le substrat SOI avec la surface de la couche d'oxyde 9 (figure 9C). On effectue la rupture de la couche de germanium 8 au niveau de la zone d'implantation d'ions et on obtient ainsi un ensemble d'une couche de germanium formant la couche de nucléation de l'empilement 10, liée à une couche support 1 en silicium par l'intermédiaire d'une couche sacrificielle 2 en oxyde de silicium. Les deux miroirs de Bragg 47A, 47B sont enterrés dans la couche support 1 au niveau de l'interface avec la couche sacrificielle 2 (figure 9D).

On réalise ensuite l'empilement semiconducteur 10 selon le premier ou le deuxième mode de réalisation, comportant une couche d'intérêt 12 à base de GeSn (non représentée) de préférence à structures de bandes directe. On obtient ensuite une structure semiconductrice 40 à partir du procédé selon le second mode de réalisation. Les miroirs de Bragg sont ainsi disposés en regard des bras tenseurs 22, voire en regard de la portion centrale 21, et encadrent la portion centrale 21 de manière à former une cavité optique (figure 9E). On dépose ensuite une couche d'encapsulation 42, par exemple en oxyde de silicium, qui recouvre la structure semiconductrice 40. On réalise enfin une jonction PIN 43, 44, 45 au travers de la couche centrale 21 et donc de la couche d'intérêt 12 (non représentée), puis on réalise des contacts électriques 46A, 46B (figure 9F). Par ailleurs, la couche support 1 peut avoir été préalablement structurée de manière à former le cœur d'un guide d'onde entourée d'une gaine formée par l'oxyde de silicium, le cœur s'étend sensiblement en regard de la portion centrale 21.

Des modes de réalisation particuliers viennent d'être décrits. Différentes variantes et modifications apparaîtront à l'homme du métier.

Ainsi, les dispositifs optoélectroniques décrits précédemment le sont à titre uniquement illustratif. D'autres dispositifs optoélectroniques peuvent être réalisés, par exemple des sources laser à pompage optique ou électrique, avec jonctions PN, PIN, ou non, voire encore des diodes électroluminescentes ou des photodétecteurs.

**Revendications**

1. Procédé de réalisation d'une couche (12) contrainte en tension à base de germanium étain (GeSn), comportant les étapes suivantes :

   a) réalisation d'un empilement semiconducteur (10) reposant sur une couche support (1) par l'intermédiaire d'une couche sacrificielle (2), ledit empilement semiconducteur (10) comportant une couche de nucléation (11) et une couche dite d'intérêt (12) à base de germanium étain (GeSn) épitaxiée à partir de la couche de nucléation (11), ledit empilement (10) présentant une valeur initiale ( $\sigma_s^i$ ) non nulle de contrainte en tension ; la couche de nucléation (11) étant réalisée en un composé semiconducteur présentant un paramètre de maille, dit naturel, inférieur à celui du matériau à base de germanium étain de la couche d'intérêt (12) et chaque couche de l'empilement semiconducteur (10) présentant une épaisseur inférieure à une épaisseur dite critique ;

b) structuration dudit empilement semiconducteur (10) de manière à former :

- une partie structurée (20) et une partie périphérique (30), la partie structurée (20) comportant une portion centrale (21) reliée à la partie périphérique (30) par au moins deux portions latérales (22) opposées l'une à l'autre vis-à-vis de la portion centrale (21),
- les portions latérales (22) présentant une largeur moyenne (b) supérieure à une largeur moyenne (a) de la portion centrale (21) ;

c) suspension de la partie structurée (20) par gravure de la couche sacrificielle (2) située sous la partie structurée (20), la portion centrale (21) dite suspendue présentant alors une valeur finale ( $\sigma_s^f$ ) de contrainte en tension supérieure à la valeur initiale ( $\sigma_s^i$ ) mettant sous tension la couche d'intérêt (12) dans la portion centrale (21).

2. Procédé selon la revendication 1, comportant les étapes suivantes :

- préalablement à l'étape a) de réalisation, estimation (110) d'une valeur ($x_{Sn}$) de proportion atomique d'étain et d'une première valeur minimale ( $\sigma_{ci}^{f,min}$ ) de contrainte en tension pour lesquelles la couche d'intérêt (12) présente une structure de bandes d'énergie directe ; et
- détermination (120) d'un empilement semiconducteur (10) comportant une couche de nucléation (11) et ladite couche d'intérêt (12) estimée, et présentant une deuxième valeur minimale ( $\sigma_s^{f,min}$ ) de contrainte en tension ;
- réalisation (130) dudit empilement semiconducteur (10) de sorte qu'il présente ladite valeur initiale ( $\sigma_s^i$ ) non nulle de contrainte en tension et que la couche d'intérêt (12) présente une valeur initiale ( $\sigma_{ci}^i$ ) inférieure à ladite première valeur minimale ( $\sigma_{ci}^{f,min}$ ) ;
- détermination (140) de la structuration de sorte que, après l'étape de suspension (150), la portion centrale (21) de la partie structurée (20) présente une valeur finale ( $\sigma_s^f$ ) de contrainte en tension supérieure ou égale à ladite deuxième valeur minimale ( $\sigma_s^{f,min}$ ), ladite couche d'intérêt (12) ayant alors une valeur finale ( $\sigma_{ci}^f$ ) de contrainte en tension supérieure ou égale à ladite première valeur minimale ( $\sigma_{ci}^{f,min}$ ) et présentant alors une structure de bandes d'énergie directe.

3. Procédé selon l'une quelconque des revendications 1 à 2, dans lequel l'empilement semiconducteur (10) comporte au moins une couche située entre la couche d'intérêt (12) et la couche de nucléation (11) et réalisée en un composé semiconducteur présentant un paramètre de maille, dit naturel, inférieur ou égal à celui du matériau à base de germanium étain de la couche d'intérêt (12).

4. Procédé selon l'une quelconque des revendications 1 à 3, dans lequel l'empilement semiconducteur (10) présente une épaisseur inférieure à une épaisseur dite critique.

5. Procédé selon l'une quelconque des revendications 1 à 4, dans lequel l'empilement semiconducteur (10) comporte des couches supérieure (13B) et inférieure (13A) à base de germanium étain, dopées selon des types de conductivité différents, situées de part et d'autre de la couche d'intérêt (12), celle-ci étant non intentionnellement dopée.

6. Procédé selon la revendication précédente, dans lequel, entre les couches dopées supérieure (13B) et inférieure (13A) d'une part et la couche d'intérêt (12) d'autre part, se situe au moins une couche dite barrière (15A, 15B) à base de germanium, ou à base de germanium étain dont la proportion atomique en étain est inférieure à la valeur de la proportion atomique d'étain de la couche d'intérêt (12).

7. Procédé selon l'une quelconque des revendications 1 à 5, dans lequel la proportion atomique d'étain de la couche d'intérêt (12) est inférieure à 10%.

8. Procédé selon l'une quelconque des revendications 1 à 7, comportant en outre une étape de mise en contact de la partie structurée (20) avec une surface rendue libre (4) de la couche support (1), de manière à rendre solidaire par collage moléculaire la partie structurée (20) de la couche support (1).

9. Procédé selon la revendication 8, comportant en outre les étapes suivantes :

- détermination d'une valeur minimale d'énergie de collage moléculaire de la partie structurée (20) sur la couche support (1), ainsi qu'une valeur minimale de surface collée des portions latérales (22), ces valeurs minimales étant telles que ladite énergie de collage moléculaire est supérieure à une énergie élastique de la partie structurée (20) ;
- recuit de consolidation à une température de recuit telle que l'énergie de collage moléculaire présente une valeur supérieure ou égale à ladite valeur minimale préalablement déterminée ; puis
- gravure d'une partie dite distale (24) des portions latérales (22) vis-à-vis de la portion centrale (21), de sorte que la surface collée des portions latérales (22) présente une valeur supérieure ou égale à ladite valeur minimale préalablement déterminée.

10. Procédé selon la revendication 8 ou 9, dans lequel l'étape de suspension et l'étape de mise en contact sont effectuées par gravure de la couche sacrificielle (2) par HF en phase vapeur éventuellement suivie par le dépôt puis l'évaporation d'un liquide entre la partie structurée (20) suspendue et la couche support (1), et dans lequel, lors de l'étape de recuit, la température de recuit est supérieure ou égale à 200°C.

11. Procédé selon la revendication 8 ou 9, comportant, lors de l'étape de suspension, une oxydation ou une nitruration d'une surface rendue libre (4) de la couche support (1) ainsi que d'une surface inférieure (23) de la partie structurée (20) orientée vers la surface libre (4), et dans lequel, lors de l'étape de recuit, la température de recuit est supérieure ou égale à 100°C.

12. Procédé selon la revendication 11, dans lequel, à la suite de l'étape de suspension, des couches diélectriques (41A, 41B), issues de l'oxydation ou de la nitruration effectuée, sont formées au niveau de la partie structurée (20) et de la couche support (1), qui présentent une épaisseur de préférence supérieure ou égale à 10nm.

13. Procédé de réalisation d'un dispositif microélectronique ou optoélectronique comportant ladite couche d'intérêt (12) à base de germanium étain obtenue par le procédé selon l'une quelconque des revendications 1 à 12, dans lequel on réalise une jonction PN (43, 45) dans la couche d'intérêt (12), ou une jonction PIN (43, 44, 45) au niveau de ladite couche d'intérêt (12), celle-ci étant alors non intentionnellement dopée.

**Patentansprüche**

1. Verfahren zum Herstellen einer spannungsbeanspruchten Schicht (12) auf Basis von Zinngermanium (GeSn), das die folgenden Schritte aufweist:

a) Herstellen eines Halbleiterstapels (10), der über eine Opferschicht (2) auf einer Trägerschicht (1) aufliegt, wobei der Halbleiterstapel (10) eine Keimbildungsschicht (11) und eine interessierende Schicht (12) auf Basis von Zinngermanium (GeSn) aufweist, die von der Keimbildungsschicht (11) epitaxiert wird, wobei der Stapel (10) einen anfänglichen spannungsbeanspruchten Wert ( $\sigma_S^i$ ) von nicht Null besitzt;
wobei die Keimbildungsschicht (11) aus einer Halbleiterverbindung hergestellt ist, die einen natürlichen Maschenparameter besitzt, der niedriger ist als der des Materials auf Basis von Zinngermanium der interessierenden Schicht (12), und jede Schicht des Halbleiterstapels (10) eine Dicke besitzt, die kleiner ist als eine kritische Dicke;
b) Strukturieren des Halbleiterstapels (10) zum Bilden von Folgendem:

- einem strukturierten Teil (20) und einem peripheren Teil (30), wobei der strukturierte Teil (20) einen zentralen Abschnitt (21) aufweist, der mit dem peripheren Teil (30) durch mindestens zwei gegenüberliegende seitliche Abschnitte (22) gegenüber dem zentralen Abschnitt (21) verbunden ist,
- wobei die Seitenabschnitte (22) eine durchschnittliche Breite (b) größer als eine durchschnittliche Breite (a) des Mittelabschnitts (21) besitzen;

c) Suspendieren des strukturierten Teils (20) durch Gravieren der unter dem strukturierten Teil (20) befindlichen Opferschicht (2), wobei der suspendierte mittlere Abschnitt (21) dann einen spannungsbeanspruchten Endwert ( $\sigma_s^f$ ) besitzt, der größer ist als der anfängliche Wert ( $\sigma_s^i$ ), der die interessierende Schicht (12) in dem mittleren Abschnitt (21) unter Spannung setzt.

2. Verfahren nach Anspruch 1, das die folgenden Schritte aufweist:

   - vor dem Schritt a) des Herstellens, Schätzen (110) eines Wertes ($xS_n$) des Atomanteils von Zinn und eines ersten spannungsbeanspruchten Mindestwertes ( $\sigma_{ci}^{f,min}$ ), für den die interessierende Schicht (12) eine Struktur von direkten Energiebändern besitzt; und
   - Bestimmen (120) eines Halbleiterstapels (10), der eine Keimbildungsschicht (11) und die geschätzte interessierende Schicht (12) aufweist und einen zweiten spannungsbeanspruchten Mindestwert ( $\sigma_s^{f,min}$ ) besitzt;
   - Herstellen (130) des Halbleiterstapels (10), so dass er den anfänglichen spannungsbeanspruchten Wert ( $\sigma_s^i$ ) von nicht Null besitzt und die interessierende Schicht (12) einen anfänglichen Wert ( $\sigma_{ci}^i$ ) besitzt, der kleiner ist als der erste Mindestwert ( $\sigma_{ci}^{f,min}$ ) ;
   - Bestimmen (140) der Strukturierung, so dass nach dem Schritt des Suspendierens (150) der mittlere Abschnitt (21) des strukturierten Teils (20) einen spannungsbeanspruchten Endwert ( $\sigma_s^f$ ) besitzt, der größer oder gleich dem zweiten Mindestwert ( $\sigma_s^{f,min}$ ) ist, wobei die interessierende Schicht (12) dann einen spannungseanspruchten Endwert ( $\sigma_{ci}^f$ ) aufweist, der größer oder gleich dem ersten Mindestwert ( $\sigma_{ci}^{f,min}$ ) ist und dann eine Struktur aus direkten Energiebändern besitzt.

3. Verfahren nach einem der Ansprüche 1 bis 2, wobei der Halbleiterstapel (10) mindestens eine Schicht aufweist, die sich zwischen der interessierenden Schicht (12) und der Keimbildungsschicht (11) befindet und aus einer Halbleiterverbindung hergestellt ist, die einen natürlichen Maschenparameter besitzt, der kleiner oder gleich dem des Materials auf Basis Zinngermanium der interessierenden Schicht (12) ist.

4. Verfahren nach einem der Ansprüche 1 bis 3, wobei der Halbleiterstapel (10) eine Dicke besitzt, die kleiner ist als eine kritische Dicke.

5. Verfahren nach einem der Ansprüche 1 bis 4, wobei der Halbleiterstapel (10) obere (13B) und untere (13A) Schichten auf Basis von Zinngermanium aufweist, die nach unterschiedlichen Leitfähigkeitstypen dotiert sind und sich auf beiden Seiten der betreffenden Schicht (12) befinden, wobei diese nicht absichtlich dotiert ist.

6. Verfahren nach dem vorhergehenden Anspruch, wobei sich zwischen den dotierten oberen (13B) und unteren (13A) Schichten einerseits und der interessierenden Schicht (12) andererseits mindestens eine Barriereschicht (15A, 15B) auf Basis von Germanium oder auf Basis von Zinngermanium befindet, deren Atomanteil an Zinn kleiner ist als der Wert des Atomanteils an Zinn der interessierenden Schicht (12).

7. Verfahren nach einem der Ansprüche 1 bis 5, wobei der Atomanteil des Zinns der interessierenden Schicht (12) weniger als 10 % beträgt.

8. Verfahren nach einem der Ansprüche 1 bis 7, das weiter einen Schritt des Inkontaktbringens des strukturierten Teils (20) mit einer freigewordenen Oberfläche (4) der Trägerschicht (1) aufweist, so dass der strukturierte Teil (20) durch molekulare Verklebung mit der Trägerschicht (1) verbunden wird.

9. Verfahren nach Anspruch 8, dass weiter folgende Schritte aufweist:

   - Bestimmen eines Mindestwertes für die molekulare Klebeenergie des strukturierten Teils (20) auf der Trägerschicht (1) sowie eines Mindestwertes für die geklebte Oberfläche der Seitenabschnitte (22), wobei diese Mindestwerte so sind, dass die molekulare Klebeenergie größer ist als eine elastische Energie des strukturierten Teils (20);
   - Konsolidierungsglühen bei einer Glühtemperatur, so dass die molekulare Klebeenergie einen Wert besitzt, der größer oder gleich dem zuvor bestimmten Mindestwert ist; dann
- Gravieren eines distalen Teils (24) der Seitenabschnitte (22) gegenüber dem mittleren Teil (21), so dass die verklebte Oberfläche der Seitenabschnitte (22) einen Wert besitzt, der größer oder gleich dem zuvor bestimmten Mindestwert ist.

10. Verfahren nach Anspruch 8 oder 9, wobei der Schritt des Suspendierens und der Schritt des Inkontaktbringens durch Ätzen der Opferschicht (2) mit HF in der Dampfphase durchgeführt werden, eventuell gefolgt von dem Ablagern und anschließendem Verdampfen einer Flüssigkeit zwischen dem suspendierten strukturierten Teil (20) und der Trägerschicht (1), und wobei bei dem Schritt des Glühens die Glühtemperatur größer oder gleich 200 °C ist.

11. Verfahren nach Anspruch 8 oder 9, das beim Schritt des Suspendierens eine Oxidation oder Nitrierung einer freigewordenen Oberfläche (4) der Trägerschicht (1) sowie einer zu der freien Oberfläche (4) gerichteten unteren Oberfläche (23) des strukturierten Teils (20) aufweist, und wobei bei dem Schritt des Glühens die Glühtemperatur größer oder gleich 100 °C ist.

12. Verfahren nach Anspruch 11, wobei nach dem Schritt des Suspendierens die dielektrischen Schichten (41A, 41B), die aus der durchgeführten Oxidation oder Nitrierung stammen, in dem Bereich des strukturierten Teils (20) und der Trägerschicht (1) gebildet werden, die eine Dicke besitzen, die vorzugsweise größer oder gleich 10nm ist.

13. Verfahren zum Herstellen einer mikro- oder optoelektronischen Vorrichtung mit der durch das Verfahren nach einem der Ansprüche 1 bis 12 erhaltenen interessierenden Schicht (12) auf Basis von Zinngermanium, wobei ein PN-Übergang (43, 45) in der interessierenden Schicht (12) oder ein PIN-Übergang (43, 44, 45) an der interessierenden Schicht (12) hergestellt wird, wobei diese dann nicht absichtlich dotiert ist.

## Claims

1. A process for producing a tensionally strained layer (12) based on germanium-tin (GeSn), comprising the following steps:

    a) producing a semiconductor stack (10) resting on a supporting layer (1) via a sacrificial layer (2), said semiconductor stack (10) comprising a nucleation layer (11) and a so-called layer of interest (12) based on germanium-tin (GeSn) grown epitaxially starting from the nucleation layer (11), said stack (10) having a non-zero initial value ( $\sigma_{s.}^{i}$ ) of tensile stress; the nucleation layer (11) being made of a semiconductor compound having a so-called natural lattice parameter, lower than that of the material based on germanium-tin of the layer of interest (12) and each layer of the semiconductor stack (10) having a thickness less than a so-called critical thickness;
    b) structuring said semiconductor stack (10) so as to form:

        - a structured part (20) and a peripheral part (30), the structured part (20) comprising a central portion (21) joined to the peripheral part (30) by at least two lateral portions (22) opposite one another with respect to the central portion (21),
        - the lateral portions (22) having an average width (b) greater than an average width (a) of the central portion (21);

    c) suspending the structured part (20) by etching the sacrificial layer (2) located beneath the structured part (20), the so-called suspended central portion (21) then having a final value ( $\sigma_{S}^{f}$ ) of tensile stress greater than the initial value ( $\sigma_{S}^{i}$ ) thereby placing the layer of interest (12) under tensile stress in the central portion (21).

2. The process as claimed in claim 1, comprising the following steps:

    - prior to the production step a), estimation (110) of a value ($x_{Sn}$) of atomic proportion of tin and of a first minimum value ( $\sigma_{ci}^{f,min}$ ) of tensile stress for which the layer of interest (12) has a direct electronic band structure; and
    - determination (120) of a semiconductor stack (10) comprising a nucleation layer (11) and said estimated layer of interest (12), and having a second minimum value ( $\sigma_{S}^{f,min}$ ) of tensile stress;

- production (130) of said semiconductor stack (10) in such a way that it has said non-zero initial value ( $\sigma_s^i$ ) of tensile stress and so that the layer of interest (12) has an initial value ( $\sigma_{ci}^i$ ) lower than said first minimum value ( $\sigma_{ci}^{f,min}$ );

- determination (140) of the structuring in such a way that, after the step of suspension (150), the central portion (21) of the structured part (20) has a final value ( $\sigma_s^f$ ) of tensile stress greater than or equal to said second minimum value ( $\sigma_s^{f,min}$ ), said layer of interest (12) then having a final value ( $\sigma_{ci}^f$ ) of tensile stress greater than or equal to said first minimum value ( $\sigma_{ci}^{f,min}$ ) and then having a direct electronic band structure.

3. The process as claimed in any one of claims 1 or 2, in which the semiconductor stack (10) comprises at least one layer located between the layer of interest (12) and the nucleation layer (11) and made of a semiconductor compound having a so-called natural lattice parameter less than or equal to that of the material based on germanium-tin of the layer of interest (12).

4. The process as claimed in any one of claims 1 to 3, in which the semiconductor stack (10) has a thickness less than a so-called critical thickness.

5. The process as claimed in any one of claims 1 to 4, in which the semiconductor stack (10) comprises upper (13B) and lower (13A) layers based on germanium-tin, doped according to different types of conductivity, located on either side of the layer of interest (12), the latter not being doped intentionally.

6. The process as claimed in the preceding claim, in which, between the upper (13B) and lower (13A) doped layers on the one hand and the layer of interest (12) on the other hand, there is at least one so-called barrier layer (15A, 15B) based on germanium, or based on germanium-tin whose atomic proportion of tin is lower than the value of the atomic proportion of tin in the layer of interest (12).

7. The process as claimed in any one of claims 1 to 5, in which the atomic proportion of tin in the layer of interest (12) is below 10%.

8. The process as claimed in any one of claims 1 to 7, further comprising a step of bringing the structured part (20) into contact with a freed surface (4) of the supporting layer (1), so as to make the structured part (20) integral with the supporting layer (1) by molecular bonding.

9. The process as claimed in claim 8, further comprising the following steps:

- determining a minimum value of molecular bonding energy of the structured part (20) on the supporting layer (1), as well as a minimum value of bonded surface area of the lateral portions (22), these minimum values being such that said energy of molecular bonding is greater than an elastic energy of the structured part (20);
- consolidation annealing at an annealing temperature such that the energy of molecular bonding has a value greater than or equal to said previously determined minimum value; and then
- etching a so-called distal part (24) of the lateral portions (22) with respect to the central portion (21), in such a way that the bonded surface of the lateral portions (22) has a value greater than or equal to said previously determined minimum value.

10. The process as claimed in claim 8 or 9, in which the step of suspension and the contacting step are carried out by etching the sacrificial layer (2) with HF in the vapor phase optionally followed by deposition and then evaporation of a liquid between the suspended structured part (20) and the supporting layer (1), and in which, in the annealing step, the annealing temperature is greater than or equal to 200°C.

11. The process as claimed in claim 8 or 9, comprising, in the suspension step, oxidation or nitriding of a freed surface (4) of the supporting layer (1) as well as of a lower surface (23) of the structured part (20) oriented towards the free surface (4), and in which, in the annealing step, the annealing temperature is greater than or equal to 100°C.

12. The process as claimed in claim 11, in which, at the end of the step of suspension, dielectric layers (41A, 41B), resulting from the oxidation or nitriding that was carried out, are formed at the level of the structured part (20) and of the supporting layer (1), which have a thickness preferably greater than or equal to 10nm.

13. The process for producing a microelectronic or optoelectronic device comprising said layer of interest (12) based on germanium-tin obtained by the process as claimed in any one of claims 1 to 12, in which a p-n junction (43, 45) is produced in the layer of interest (12), or a p-i-n junction (43, 44, 45) at the level of said layer of interest (12), the latter then not being doped intentionally.

**Fig.1A**

**Fig.1B**

**Fig.1C**

**Fig.2A**

**Fig.2B**

**Fig.2C**

**110**

$$\left\{ \mathbf{x_{Sn}} \; ; \sigma_{ci}^{f,min} > 0 \right\} / \Delta E \geq 0$$

**120**

$$G / \begin{cases} \sigma_{ci}^{f,min} = \mathbf{G}(\sigma_{s}^{f,min}) \\ \sigma_{s}^{f,min} > 0 \\ \sigma_{ci}^{f,min} > 0 \end{cases}$$

**130**

$$\begin{cases} \sigma_{ci}^{i} = \mathbf{G}(\sigma_{s}^{i}) \\ \sigma_{s}^{f,min} > \sigma_{s}^{i} > 0 \\ \sigma_{ci}^{f,min} > \sigma_{ci}^{i} \end{cases}$$

**140**

$$F / \begin{cases} \sigma_{s}^{f} = \mathbf{F}(\sigma_{s}^{i}) \\ \sigma_{s}^{f} \geq \sigma_{s}^{f,min} \\ \sigma_{ci}^{f} \geq \sigma_{ci}^{f,min} \end{cases}$$

**150**

$$\begin{cases} \sigma_{s}^{i} \\ \sigma_{ci}^{i} \end{cases} \rightarrow \begin{cases} \sigma_{s}^{f} = F(\sigma_{s}^{i}) \geq \sigma_{s}^{f,min} \\ \sigma_{ci}^{f} = G(\sigma_{s}^{f}) \geq \sigma_{ci}^{f,min} \end{cases}$$

**Fig.3**

**Fig.4A**

**Fig.4B**

**Fig.4C**

**Fig.5A**

**Fig.5B**

**Fig.5C**

**Fig.6A**

**Fig.6B**

**Fig.6C**

**Fig.7A**

**Fig.7B**

**Fig.8A**

**Fig.8B**

**Fig.9A**

**Fig.9B**

**Fig.9C**

**Fig.9D**

**Fig.9E**

**Fig.9F**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- FR 1559283

**Littérature non-brevet citée dans la description**

- **WIRTHS et al.** Tensely strained GeSn alloy as optical gain media. *Appl. Phys. Lett.*, 2013, vol. 103, 192110
- **REBOUD et al.** Structural and optical properties of 200 mm germanium-on-insulator (GeOI) substrates for silicon photonics applications. *Proc. SPIE 9367, Silicon Photonics X*, 27 February 2015, 936714
- **JAN et al.** Tensile-strained germanium-on-insulator substrate for silicon-compatible optoelectronics. *Opt. Mater. Express*, 2011, vol. 1, 1121-1126
- **SÜESS et al.** Analysis of enhanced light emission from highly strained germanium microbridges. *Nature Photon.*, 2013, vol. 7, 466-472